(19) Europäisches Patentamt
European Patent Office
Office européen des brevets

(11) EP 1 296 187 A2

(12) EUROPEAN PATENT APPLICATION

(43) Date of publication:
26.03.2003 Bulletin 2003/13

(51) Int Cl.[7]: G03F 7/028, G03F 7/09

(21) Application number: 02021329.4

(22) Date of filing: 20.09.2002

(84) Designated Contracting States:
AT BE BG CH CY CZ DE DK EE ES FI FR GB GR IE IT LI LU MC NL PT SE SK TR
Designated Extension States:
AL LT LV MK RO SI

(30) Priority: 21.09.2001 JP 2001289251

(71) Applicant: FUJI PHOTO FILM CO., LTD.
Kanagawa-ken (JP)

(72) Inventor: Oshima, Yasuhito
Yoshida-cho, Haibara-gun, Shizuoka (JP)

(74) Representative: HOFFMANN - EITLE
Patent- und Rechtsanwälte
Arabellastrasse 4
81925 München (DE)

# (54) Photopolymerizable lithographic printing plate

(57) A photopolymerizable lithographic printing plate having a photosensitive layer containing a photopolymerization initiator, a compound having an ethylenically unsaturated double bond and a polymer binder, and a protective layer provided in this order on a hydrophilic support, wherein an amount of the compound having an ethylenically unsaturated double bond in the photosensitive layer is from 30% to 70% by weight, and oxygen permeability of the protective layer is from 1 x $10^{-15}$ to 1 x $10^{-1}$ [$cm^3$(STP)·cm/$cm^2$·sec·cmHg].

EP 1 296 187 A2

## Description

### FIELD OF THE INVENTION

The present invention relates to a photopolymerizable lithographic printing plate and more particularly to a photopolymerizable lithographic printing plate having high sensitivity and high contrast.

### BACKGROUND OF THE INVENTION

A high output small-sized solid laser, semiconductor laser and gas laser for emitting ultraviolet rays, visible light or infrared rays having a wavelength of from 300 nm to 1,200 nm are easily available. These lasers are very useful as light source for process which comprises making a printing plate directly from digital data from computer, etc.

Various recording materials sensitive to these laser beams have been studied. Representative examples of the recording material include firstly recording materials capable of being recorded with an infrared laser having a wavelength of 760 nm or more, for example, positive-working recording materials disclosed in U.S. Patent 4,708,925 and acid catalyst-crosslinkable negative-working recording materials disclosed in Japanese Patent Laid-Open No. 1997-276558.

Secondly, the examples of the recording material include recording materials responsive to an ultraviolet ray or visible light laser having a wavelength of from 300 nm to 700 nm, for example, radical-polymerizable negative-working recording materials disclosed in U.S. Patent 2,850,445 and Japanese Patent Publication No. 1969-20189.

The problem common to all these image-forming materials is how much the ON-OFF latitude of image can be expanded on the area irradiated with the aforementioned various energy rays and the unexposed area, that is, how much both the high sensitivity and storage stability of the image-forming material can be attained.

In general, a radical polymerization system is highly sensitive but is drastically deteriorated in its sensitivity when its polymerization is inhibited by oxygen in the air. In order to prevent such a trouble, it is practiced to provide an oxygen barrier protective layer on the image-forming layer. However, when such an oxygen barrier protective layer is provided, the resulting recording material has a raised sensitivity. As a result, a slight amount of radicals generated by scattered light during exposure causes even the non-image area to be hardened, resulting in the occurrence of scumming during printing, i.e., a problem of so-called flare. In order to eliminate the flare, it is effective to raise the contrast of photosensitive material. However, the prior art can difficultly attain both high sensitivity and high contrast.

### SUMMARY OF THE INVENTION

It is therefore an object of the invention to provide a high contrast photopolymerizable lithographic printing plate having a high sensitivity and an excellent flare resistance, i.e., little scumming, among radical-polymerizable photosensitive materials having the highest sensitivity in the art of image formation.

It is another object of the invention to provide a photopolymerizable lithographic printing plate which can be subjected to plate-making directly from digital data from computer or the like by recording using a solid laser or semiconductor laser emitting ultraviolet rays, visible light or infrared rays.

The inventors made extensive studies of these problems. As a result, it was found that the use of a low oxygen barrier protective layer rather than high oxygen barrier protective layer, which is a common sense in the art, makes it possible to allow oxygen to catch a slight amount of radicals generated by scattered light, inhibiting the hardening of the non-image area and hence eliminating flare. However, the use of such a low oxygen barrier protective layer also causes the reduction of sensitivity of photosensitive layer. The reduction of sensitivity can be compensated by increasing the content of polymerizable compounds in the photosensitive layer. As a result, an unprecedented, high contract photopolymerizable lithographic printing plate having high sensitivity and excellent flare resistance leading to no scumming can be obtained, thereby completing the present invention.

The invention provides a photopolymerizable lithographic printing plate comprising a photosensitive layer containing a photopolymerization initiator, a compound having an ethylenically unsaturated double bond and a polymer binder, and a protective layer provided in this order on a hydrophilic support, wherein an amount of the compound having an ethylenically unsaturated double bond in the photosensitive layer is from 30% to 70 by weight based on the total weight of the photosensitive layer, and oxygen permeability of the protective layer is from 1 x $10^{-15}$ to 1 x $10^{-1}$ [$cm^3$(STP)·cm/$cm^2$·sec·cmHg].

### DETAILED DESCRIPTION OF THE INVENTION

The photosensitive layer of the photopolymerizable lithographic printing plate of the invention contains as essential components a photopolymerization initiator, a compound having an ethylenically unsaturated double bond

(hereinafter also referred simply to as "ethylenically unsaturated compound" sometimes) and a polymer binder. The content of ethylenically unsaturated compound is not smaller than 30% by weight. If desired, the photosensitive layer may further contain various compounds such as coloring agent, plasticizer and thermal polymerization inhibitor.

The ethylenically unsaturated compound to be incorporated in the photosensitive layer of the photopolymerizable lithographic printing plate of the invention is a compound having an ethylenically unsaturated bond, which undergoes addition polymerization, crosslinking and hardening upon the action of a photopolymerization initiator described in detail below when the photopolymerizable photosensitive layer is irradiated with active rays.

The addition-polymerizable compound having an ethylenically unsaturated double bond can be appropriately selected from compounds having at least one, preferably two or more ethylenically unsaturated bonds.

The addition-polymerizable compound is in a chemical form, for example, a monomer, a prepolymer, e.g., dimmer or trimer, an oligomer, a mixture thereof or a copolymer thereof. Copolymers containing addition polymerizable groups in their side chains are also preferably used.

Examples of the monomer include ester of unsaturated carboxylic acid (e.g., acrylic acid, methacrylic acid, itaconic acid, crotonic acid, isocrotonic acid or maleic acid) with aliphatic polyhydric alcohol compound, and amide of the unsaturated carboxylic acid with aliphatic polyvalent amine compound.

Specific examples of the ester of aliphatic polyhydric alcohol compound with unsaturated carboxylic acid include acrylic acid esters such as ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri (acryloyloxypropyl)ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl)isocyanurate and polyester acrylate oligomer, methacrylic acid esters such as tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis [p-(3-methacryloxy-2-hydroxypropoxy) phenyl]dimethylmethane and bis-[p-(methacryloxyethoxy)phenyl] dimethylmethane, itaconic acid esters such as ethylene glycol diitaconate, propylene glycol diitaconate, 1,3-butanediol diitaconate, 1,4-butanediol diitaconate, tetramethylene glycol diitaconate, pentaerythritol diitaconate and sorbitol tetraitaconate, crotonic acid esters such as ethylene glycol dicrotonate, tetramethylene glycol dicrotonate, pentaerythritol dicrotonate and sorbitol tetradicrotonate, isocrotonic acid esters such as ethylene glycol diisocrotonate, pentaerythritol diisocrotonate and sorbitol tetraisocrotonate, and maleic acid esters such as ethylene glycol dimaleate, triethylene glycol dimaleate, pentaerythritol dimaleate and sorbitol tetramaleate. A mixture of the aforementioned ester monomers is also used.

Specific examples of the amide of aliphatic polyvalent amine compound with unsaturated carboxylic acid include methylene bisacrylamide, methylene bismetharylamide, 1, 6-hexamethylene bisacrylamide, 1,6-hexamethylene bismethacrylamide, diethylenetriamine trisacylamide, xylylene bisacrylamide, and xylylene bismethacrylamide.

Other examples of the ethylenically unsaturated compound include vinylurethane compound containing two or more polymerizable vinyl groups per molecule obtained by adding a vinyl monomer having a hydroxyl group represented by the following formula (A) to a polyisocyanate compound containing two or more isocyanate groups per molecule as disclosed in Japanese Patent Publication No. 1973-41708.

$$CH_2=C(R^3)COOCH_2CH(R^4)OH \qquad (A)$$

wherein $R^3$ and $R^4$ each represent H or $CH_3$.

Further examples of the ethylenically unsaturated compound include urethaneacrylates as disclosed in Japanese Patent Laid-Open No. 1976-37193 and Japanese Patent Publication No. 1990-32293, polyester acrylates as disclosed in Japanese Patent Laid-Open No. 1973-64183, Japanese Patent Publication No. 1974-43191 and Japanese Patent Publication No. 1977-30490, polyester acrylates as disclosed in Japanese Patent Publication No. 1977-30490, and polyfunctional acrylates or methacrylates such as epoxy acrylate obtained by the reaction of epoxy resin with (meth)acrylic acid. Further, compounds described as photosetting monomer and oligomer in "Journal of Japan Adhesive Industry Association", vol. 20, No. 7, pp. 300 - 308 (1984) may be used.

Moreover, α-hetero monomers having a structure represented by formula (I) shown below as disclosed in Japanese Patent Laid-Open No. 2001-92127 have a high sensitivity and thus are particularly preferred monomers.

(I) 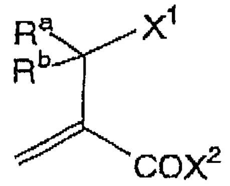

wherein $X^1$ and $X^2$, which may be the same or different, each represent a halogen atom or a group connected through a hetero atom; $R^a$ and $R^b$, which may be the same or different, each represent a hydrogen atom, a halogen atom, a cyano group or an organic residue; or $X^1$ and $X^2$, $R^a$ and $R^b$, or $X^1$ and $R^a$ or $R^b$ may combine with each other to form a cyclic structure.

The structure represented by formula (I) may form a monovalent or two or more valent substituent, or a compound in which all of $R^a$, $R^b$, $X^1$ and $X^2$ in formula (I) each represents a terminal group. When the structure represented by formula (I) forms a monovalent or two or more valent substituent, at least one of $R^a$, $R^b$, $X^1$ and $X^2$ in formula (I) has one or more connecting bonds. Further, $X^1$ or $X^2$ in formula (I) may form a connecting group having n's connectable parts, to terminals of which n's groups represented by formula (I) are bonded (wherein n represents an integer of 2 or more) (multifunctional compound).

Moreover, the structure represented by formula (I) may be bonded to a polymer chain at $X^1$ or $X^2$. In such a case, the structures represented by formula (I) are present in side chains of the polymer chain. The polymer chain includes a linear organic polymer described hereinafter. Specific examples of the polymer include a vinyl polymer, e. g., polyurethane, novolak or polyvinyl alcohol, polyhydroxystyrene, polystyrene, poly(meth)acrylic ester, poly(meth) acrylamide and polyacetal. The polymer may be a homopolymer or copolymer.

In formula (I), $X^1$ or $X^2$ represents a halogen atom or a group connected through a hetero atom, and may be a terminal group or a connecting group bonding to another substituent (the substituent includes the structure represented by formula (I) and polymer chain as described above). The hetero atom is preferably a non-metallic atom, and specifically includes an oxygen atom, a sulfur atom, a nitrogen atom and a phosphorus atom. The halogen atom include, for example, a chlorine atom, a bromine atom, an iodine atom and a fluorine atom.

$X^1$ is preferably a halogen atom or as the group connected through a hetero atom, a hydroxy group, a substituted oxy group, a mercapto group, a substituted thio group, an amino group, a substituted amino group, a sulfo group, a sulfonato group, a substituted sulfinyl group, a substituted sulfonyl group, a phosphono group, a substituted phosphono group, a phosphonato group, a substituted phosphonato group, a nitro group or a heterocyclic group that is connected through a hetero atom included therein.

$X^2$ is preferably a halogen atom or as the group connected through a hetero atom, a hydroxy group, a substituted oxy group, a mercapto group, a substituted thio group, an amino group, a substituted amino group or a heterocyclic group that is connected through a hetero atom included therein.

In the case wherein $X^1$ or $X^2$ represents a connecting group to which another substituent is bonded, n's groups represented by formula (I) may be bonded to terminals of a connecting group having n's connectable parts obtained by eliminating n's hydrogen atoms (wherein n represents an integer of 2 or more).

Also, $X^1$ or $X^2$ may combine with each other to form a cyclic structure.

Ra and $R^b$, which may be the same or different, each represents preferably a hydrogen atom, a halogen atom, a cyano group or as the organic residue, a hydrocarbon group which may have a substituent and/or an unsaturated bond, a substituted oxy group, a substituted thio group, a substituted amino group, a substituted carbonyl group or a carboxylato group.

Also, $R^a$ and $R^b$ may combine with each other to form a cyclic structure.

Each of the substituents included in $X^1$, $X^2$, $R^a$ and $R^b$ in formula (I) is described below.

The hydrocarbon group which may have a substituent and/or an unsaturated bond includes an alkyl group, a substituted alkyl group, an aryl group, a substituted aryl group, an alkenyl group, a substituted alkenyl group an alkynyl group and a substituted alkynyl group.

The alkyl group includes a straight chain, branched or cyclic alkyl group having from 1 to 20 carbon atoms. Specific examples thereof include methyl, ethyl, propyl, butyl, pentyl, hexyl, heptyl, octyl, nonyl, decyl, undecyl, dodecyl, tridecyl, hexadecyl, octadecyl, eicosyl, isopropyl, isobutyl, sec-butyl, tert-butyl, isopentyl, neopentyl, 1-methylbutyl, isohexyl, 2-ethylhexyl, 2-methylhexyl, cyclohexyl, cyclopentyl and 2-norbornyl groups. Of the alkyl groups, a straight chain alkyl group having from 1 to 12 carbon atoms, a branched alkyl group having from 3 to 12 carbon atoms and a cyclic alkyl group having from 5 to 10 carbon atoms are preferred.

The substituted alkyl group is composed of a substituent bonding to an alkylene group. The substituent includes a monovalent non-metallic atomic group exclusive of a hydrogen atom. Preferred examples of the substituent

for the alkyl group include a halogen atom (e.g., fluorine, bromine, chlorine or iodine), a hydroxy group, an alkoxy group, an aryloxy group, a mexcapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, N'-arylureido group, an N',N'-diarylureido group, an N'-alkyl-N'-arylureido group, an N-alkylureido group, N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, an acyl group, a carboxy group and a conjugate base group thereof (hereinafter, referred to as a carboxylato group), an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group ($-SO_3H$) and a conjugate base group thereof (hereinafter, referred to as a sulfonato group) , an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, an N-acylsulfamoyl group and a conjugate base group thereof, an N-alkylsulfonylsulfamoyl group ($-SO_2NHSO_2$(alkyl)) and a conjugate base group thereof, an N-arylsulfonylsulfamoyl group ($-SO_2NHSO_2$(aryl)) and a conjugate base group thereof, an N-alkylsulfonylcarbamoyl group ($-CONHSO_2$(alkyl)) and a conjugate base group thereof, an N-arylsulfonylcarbamoyl group ($-CONHSO_2$(aryl)) and a conjugate base group thereof, an alkoxysilyl group ($-Si(O\text{-alkyl})_3$), an aryloxysilyl group ($-Si(O\text{-aryl})_3$), a hydroxysilyl group ($-Si(OH)_3$) and a conjugate base group thereof, a phosphono group ($-PO_3H_2$) and a conjugate base group thereof (hereinafter, referred to as a phosphonato group), a dialkylphosphono group ($-PO_3(\text{alkyl})_2$), a diarylphosphono group ($-PO_3(\text{aryl})_2$), an alkylarylphosphono group ($-PO_3$(alkyl)(aryl)), a monoalkylphosphono group ($-PO_3H$(alkyl)) and a conjugate base group thereof (hereinafter, referred to as an alkylphosphonato group), a monoarylphosphono group ($-PO_3H$(aryl)) and a conjugate base group thereof (hereinafter, referred to as an arylphosphonato group), a phosphonoxy group ($-OPO_3H_2$) and a conjugate base group thereof (hereinafter, referred to as a phosphonatoxy group), a dialkylphosphonoxy group ($-OPO_3(\text{alkyl})_2$), a diarylphosphonoxy group ($-OPO_3(\text{aryl})_2$), an alkylarylphosphonoxy group ($-OPO_3$(alkyl)(aryl)), a monoalkylphosphonoxy group ($-OPO_3H$(alkyl)) and a conjugate base group thereof (hereinafter, referred to as an alkylphosphonatoxy group), a monoarylphosphonoxy group ($-OPO_3H$(aryl)) and a conjugate base group thereof (hereinafter, referred to as an arylphosphonatoxy group), a cyano group, a nitro group, an aryl group, an alkenyl group and an alkynyl group.

Specific examples of the alkyl group in the substituents include those described above. Specific examples of the aryl group in the substituents include phenyl, biphenyl, naphthyl, tolyl, xylyl, mesityl, cumenyl, fluorophenyl, chlorophenyl, bromophenyl, chloromethylphenyl, hydroxyphenyl, methoxyphenyl, ethoxyphenyl, phenoxypnenyl, acetoxyphenyl, benzoyloxyphenyl, methylthiophenyl, phenylthiophenyl, methylaminophenyl, dimethylaminophenyl, acetylaminophenyl, carboxyphenyl, methoxycarbonylphenyl, ethoxycarbonylphenyl, phenoxycarbonylphenyl, N-phenylcarbamoylphenyl, phenyl, nitrophenyl, cyanophenyl, sulfophenyl, sufonatophenyl, phosphonophenyl and phosphonatophenyl groups. Specific examples of the alkenyl group include vinyl, 1-propenyl, 1-butenyl, cinnamyl and 2-chloro-1-ethenyl groups. Specific examples of the alkynyl group include ethynyl, 1-propynyl, 1-butynyl, trimethylsilylethynyl and phenylethynyl groups.

In the acyl group ($R^4CO-$) described above, $R^4$ represents a hydrogen atom, or the above-described alkyl group, aryl group, alkenyl group or alkynyl group.

In the substituted alkyl group, an alkylene group includes a divalent organic residue obtained by eliminating any one of hydrogen atoms on the alkyl group having from 1 to 20 carbon atoms described above, and preferably a straight chain alkylene group having from 1 to 12 carbon atoms, a branched alkylene group having from 3 to 12 carbon atoms and a cyclic alkylene group having from 5 to 10 carbon atoms. Specific preferred examples of the substituted alkyl group include chloromethyl, bromomethyl, 2-chloroethyl, trifluoromethyl, methoxymethyl, methoxyethoxyethyl, allyloxymethyl, phenoxymethyl, methyltiomethyl, tolylthiomethyl, ethylaminoethyl, diethylaminopropyl, morpholinopropyl, acetyloxymethyl, benzoyloxymethyl, N-cyclohexylcarbamoyloxyethyl, N-phenylcarbamoyloxyethyl, acetylaminoethyl,. N-methylbenzoylaminopropyl, 2-oxoethyl, 2-oxopropyl, carboxypropyl, methoxycarbonylethyl, methoxycarbonylmethyl, methoxycarbonylbutyl, ethoxycarbonylmethyl, butoxycarbonylmethyl, allyloxycarbonylmethyl, benzyloxycarbonylmethyl, methoxycarbonylphenylmethyl, trichloromethylcarbonylmethyl, allyloxycarbonylbutyl, chlorophenoxycarbonylmethyl, carbamoylmethyl, N-methylcarbamoylethyl, N,N-dipropylcarbamoylmethyl, N-(methoxyphenyl)carbamoylethyl, N-methyl-N-(sulfophenyl)carbamoylmethyl, sulfopropyl, sulfobutyl, sulfonatobutyl, sulfamoylbutyl, N-ethylsulfamoylmethyl, N,N-dipropylsulfamoylpropyl, N-tolylsulfamoylpropyl, N-methyl-N-(phosphonophenyl)sulfamoyloctyl,

$CH_3CONHSO_2CH_2CH_2CH_2CH_2$- ,

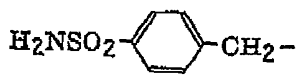 、

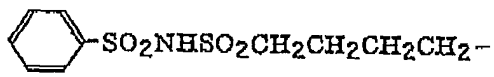 、

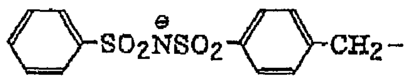 、

HS-$CH_2CH_2CH_2CH_2$- ,

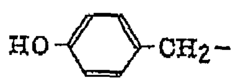 、

phosphonobutyl, phosphonatohexyl, diethylphosphonobutyl, diphenylphosphonopropyl, methylphosphonobutyl, methylphosphonatobutyl, tolylphosphonohexyl, tolylphosphonatohexyl, phosphonoxypropyl, phosphonatoxybutyl, benzyl, phenethyl, $\alpha$-methylbenzyl, 1-methyl-1-phenylethyl, p-methylbenzyl, cinnamyl, allyl, 1-propenylmethyl, 2-butenyl, 2-methylallyl, 2-methylpropenylmethyl, 2-propynyl, 2-butynyl and 3-butynyl groups.

The aryl group includes a condensed ring of one to three benzene rings and a condensed ring of a benzene ring and a 5-membered unsaturated ring. Specific examples of the aryl group include phenyl, naphthyl, anthryl, phenanthryl, indenyl, acenaphthenyl and fluorenyl groups. A phenyl group and a naphthyl group are preferred.

The substituted aryl group is a group formed by bonding a substituent to an aryl group and includes groups having a monovalent non-metallic atomic group exclusive of a hydrogen atom, as a substituent, on the ring-forming carbon atom of the above-described aryl group. Examples of the substituent include the above-described alkyl and substituted alkyl group and the substituents for the substituted alkyl group. Specific preferred examples of the substituted aryl group include biphenyl, tolyl, xylyl, mesityl, cumenyl, chlorophenyl, bromophenyl, fluorophenyl, chloromethylphenyl, trifluoromethylphenyl, hydroxyphenyl, methoxyphenyl, methoxyethoxyphenyl, allyloxyphenyl, phenoxyphenyl, methylthiophenyl, tolylthiophenyl, phenylthiophenyl, ethylaminophenyl, diethylaminophenyl, morpholinophenyl, acetyloxyphenyl, benzoyloxyphenyl, N-cyclohexylcarbamoyloxyphenyl, N-phenylcarbamoyloxyphenyl, acetylaminophenyl, N-methylbenzoylaminophenyl, carboxyphenyl, methoxycarbonylphenyl, allyloxycarbonylphenyl, chlorophenoxycarbonylphenyl, carbamoylphenyl, N-methylcarbamoylphenyl, N,N-dipropylcarbamoylphenyl, N-(methoxyphenyl) carbamoylphenyl, N-methyl-N-(sulfophenyl)carbamoylphenyl, sulfophenyl, sulfonatophenyl, sulfamoylphenyl, N-ethylsulfamoylphenyl, N,N-dipropylsulfamoylphenyl, N-tolylsulfamoylphenyl, N-methyl-N- (phosphonophenyl)sulfamoylphenyl, phosphonophenyl, phosphonatophenyl, diethylphosphonophenyl, diphenylphosphonophenyl, methylphosphonophenyl, methylphosphonatophenyl, tolylphosphonophenyl, tolylphosphonatophenyl, allylphenyl, 1-propenylmethylphenyl, 2-butenylphenyl, 2-methylallylphenyl, 2-methylpropenylphenyl, 2-propynylphenyl, 2-butynylphenyl and 3-butynylphenyl groups.

The alkenyl group includes that described above. The substituted alkenyl group is a group formed by replacing a hydrogen atom of the alkenyl group with a substituent. Examples of the substituent include the substituents for the substituted alkyl group described above, and the alkenyl group is that described above. Preferred examples of the substituted alkenyl group include the following groups:

$CH_3O_2CCH_2CH{=}CHCH_2$- ,

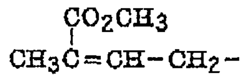 、

$HO_2CCH_2CH{=}CHCH_2$- ,

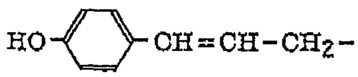 、

$CH_2{=}CH$-$CH{=}CH$-$CH_2$- , Cl-$CH_2CH{=}CHCH_2$- ,

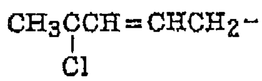 、

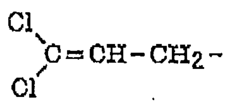 、

HS-$CH_2CH{=}CHCH_2$-

The alkynyl group includes that described above. The substituted alkynyl group is a group formed by replacing a hydrogen atom of the alkynyl group with a substituent. Examples of the substituent include the substituents for the substituted alkyl group described above, and the alkynyl group is that described above.

The heterocyclic group includes a monovalent group formed by eliminating one hydrogen atom on the hetero ring and a monovalent group (a substituted heterocyclic group) formed by further eliminating one hydrogen atom from the above-described monovalent group and bonding a substituent selected from the substituents for the substituted alkyl group described above. Preferred examples of the hetero ring are set forth below.

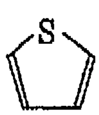 , 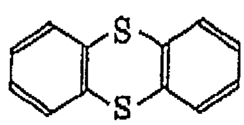 , 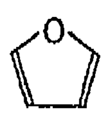 , 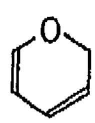 ,

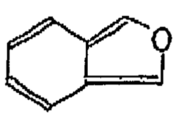 , 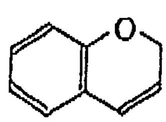 , 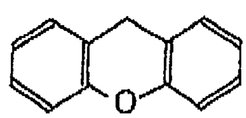 ,

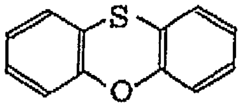 , 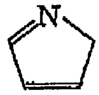 , 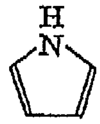 , 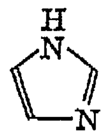 ,

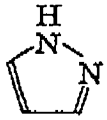 , 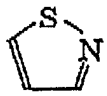 , 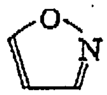 , 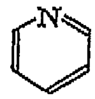 ,

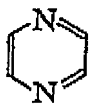 , 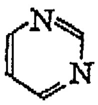 , 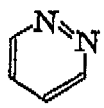 , 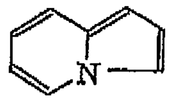 ,

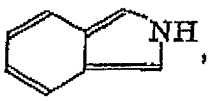 , 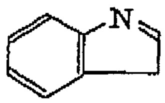 , 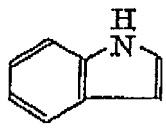 , 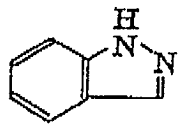 ,

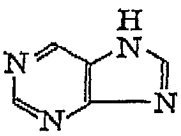 , 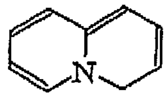 , 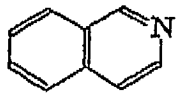 , 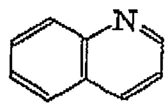 ,

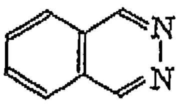 , 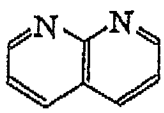 , 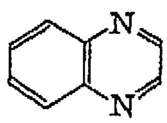 , 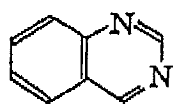 ,

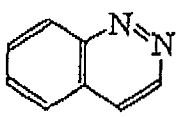 , 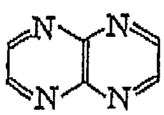 , 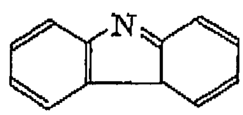 ,

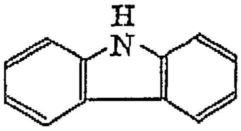 , 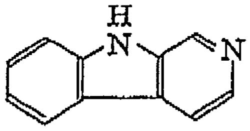 , 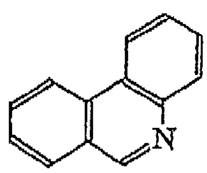 ,

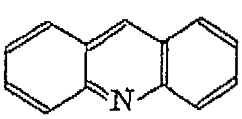 , 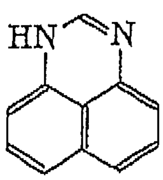 , 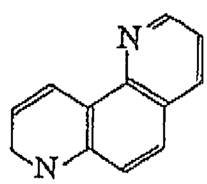 ,

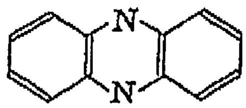 , 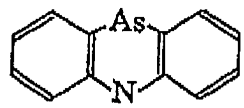 , 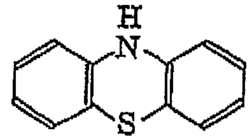 ,

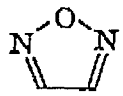 , 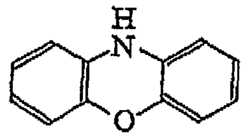 , 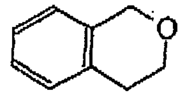 ,

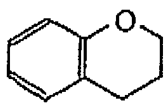 , 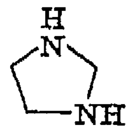 , 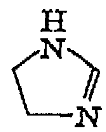 , 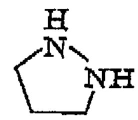 ,

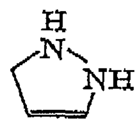 , 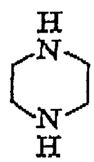 , 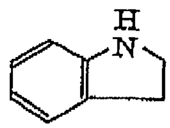 , 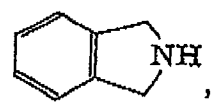 ,

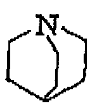 , 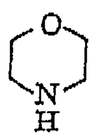 , 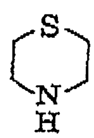 , 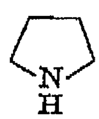 ,

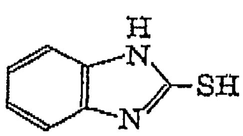 , 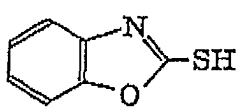 , 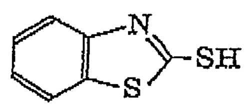 ,

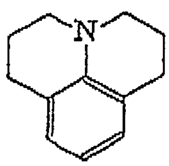 , 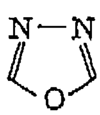 , 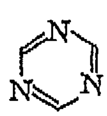 , 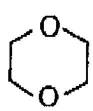

In the substituted oxy group ($R^5O$-) described above, $R^5$ represents a monovalent non-metallic atomic group excusive of a hydrogen atom. Preferred examples of the substituted oxy group include an alkoxy group, an aryloxy group, an acyloxy group, a carbamoyloxy group, an N-alkylcarbamoyloxy group, an N-arylcarbamoyloxy group, an N, N-dialkylcarbamoyloxy group, an N,N-diarylcarbamoyloxy group, an N-alkyl-N-arylcarbamoyloxy group, an alkylsulfoxy group, an arylsulfoxy group, a phosphonoxy group and a phosphonatoxy group. The alkyl group and aryl group in the above-described substituted oxy group include those described for the alkyl group, substituted alkyl group, aryl group

and substituted aryl group above. In an acyl group ($R^6CO$-) in the acyloxy group described above, $R^6$ represents the alkyl group, substituted alkyl group, aryl group and substituted aryl group described above. Of the substituted oxy groups, an alkoxy group, an aryloxy group, an acyloxy group and an arylsulfoxy group are more preferred. Specific preferred examples of the substituted oxy group include methoxy, ethoxy, propyloxy, isopropyloxy, butyloxy, pentyloxy, hexyloxy, dodecyloxy, benzyloxy, allyloxy, phenethyloxy, carboxyethyloxy, methoxycarbonylethyloxy, ethoxycarbonylethyloxy, methoxyethoxy, phenoxyethoxy, methoxyethoxyethoxy, ethoxyethoxyethoxy, morpholinoethoxy, morpholinopropyloxy, allyloxyethoxyethoxy, phenoxy, tolyloxy, xylyloxy, mesityloxy, cumenyloxy, methoxyphenyloxy, ethoxyphenyloxy, chlorophenyloxy, bromophenyloxy, acetyloxy, benzoyloxy, naphthyloxy, phenylsulfonyloxy, phosphonoxy and phosphonatoxy groups.

In the substituted thio group ($R^7S$-) described above, $R^7$ represents a monovalent non-metallic atomic group excusive of a hydrogen atom. Preferred examples of the substituted thio group include an alkylthio group, an arylthio group, an alkyldithio group, an aryldithio group and an acylthio group. The alkyl group andaryl group in the above-described substituted thio group include those described for the alkyl group, substituted alkyl group, aryl group and substituted aryl group above. In an acyl group ($R^6CO$-) in the acylthio group described above, $R^6$ has the same meaning as described above. Of the substituted thio groups, an alkylthio group and an arylthio group are more preferred. Specific preferred examples of the substituted thio group include methylthio, ethylthio, phenylthio, ethoxyethylthio, carboxyethylthio and methoxycarbonylthio groups.

In the substituted amino group ($R^8NH$- or ($R^9$) ($R^{10}$)N-) described above, $R^8$, $R^9$ and $R^{10}$ each represents a monovalent non-metallic atomic group excusive of a hydrogen atom. Preferred examples of the substituted amino group include an N-alkylamino group, an N,N-dialkylamino group, an N-arylamino group, an N,N-diarylamino group, an N-alkyl-N-arylamino group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-M-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group and an N-aryl-N-aryloxycarbonylamino group. The alkyl group and aryl group in the above-described substituted amino group include those described for the alkyl group, substituted alkyl group, aryl group and substituted aryl group above. In an acyl group ($R^6CO$-) in the acylamino group, N-alkylacylamino group or N-arylacylamino group described above, $R^6$ has the same meaning as described above. Of the substituted amino groups, an N-alkylamino group, an N,N-dialkylamino group, an N-arylamino group and an acylamino group are more preferred. Specific preferred examples of the substituted amino group include methylamino, ethylamino, diethylamino, morpholino, piperidino, pyrrolidino, phenylamino, benzoylamino and acetylamino groups.

In the substituted carbonyl group ($R^{11}$-CO-) described above, $R^{11}$ represents a monovalent non-metallic atomic group excusive of a hydrogen atom. Preferred examples of the substituted carbonyl group include an acyl group, a carboxy group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group and an N-alkyl-N-arylcarbamoyl group. The alkyl group and aryl group in the above-described substituted carbonyl group include those described for the alkyl group, substituted alkyl group, aryl group and substituted aryl group above. Of the substituted carbonyl groups, an acyl group, a carboxy group, an alkoxycarbonyl group, an aryloxycarbonyl group, a carbamoyl group, an N-alkylcarbamoyl group, an N,N-dialkylcarbamoyl group and an N-arylcarbamoyl group are more preferred, and an acyl group, an alkoxycarbonyl group and an aryloxycarbonyl group are still more preferred. Specific preferred examples of the substituted carbonyl group include formyl, acetyl, benzoyl, carboxy, methoxycarbonyl, allyloxycarbonyl, N-methylcarbamoyl, N-phenylcarbamoyl, N,N-diethylcarbamoyl and morpholinocarbonyl groups

In the substituted sulfinyl group ($R^{12}$-SO-) described above, $R^{12}$ represents a monovalent non-metallic atomic group excusive of a hydrogen atom. Preferred examples of the substituted sulfinyl group include an alkylsulfinyl group, an arylsulfinyl group, a sulfinamoyl group, an N-alkyl sulfinamoyl group, an N,N-dialkylsulfinamoyl group, an N-arylsulfinamoyl group, an N,N-diarylsulfinamoyl group and an N-alkyl-N-arylsulfinamoyl group. The alkyl group and aryl group in the above-described substituted sulfinyl group include those described for the alkyl group, substituted alkyl group, aryl group and substituted aryl group above. Of the substituted sulfinyl groups, an alkylsulfinyl group and an arylsulfinyl group are more preferred. Specific examples of the substituted sulfinyl group include hexylsulfinyl, benzylsulfinyl and tolylsulfinyl groups.

In the substituted sulfonyl group ($R^{13}$-$SO_2$-) described above, $R^{13}$ represents a monovalent non-metallic atomic group excusive of a hydrogen atom. Preferred examples of the substituted sulfonyl group include an alkylsulfonyl group and an arylsulfonyl group. The alkyl group and aryl group in the above-described substituted sulfonyl group include those described for the alkyl group, substituted alkyl group, aryl group and substituted aryl group above. Specific examples of the substituted sulfonyl group include butylsulfonyl and chlorophenylsulfonyl groups.

The sulfonato group ($-SO_3^-$) described above means a conjugate base anion group of a sulfo group ($-SO_3H$) as described above. Ordinarily, it is preferred to use together with a counter cation. Examples of the counter cation include those conventionally known, for example, various oniums (e.g., ammonium, sulfonium, phosphonium iodonium or azinium) and metal ions (e.g., $Na^+$, $K^+$, $Ca^{2+}$ or $Zn^{2+}$).

The calboxylato group ($-CO_2^-$) described above means a conjugate base anion group of a carboxy group ($-CO_2H$) as described above. Ordinarily, it is preferred to use together with a counter cation. Examples of the counter cation include those conventionally known, for example, various oniums (e.g., ammonium, sulfonium, phosphoniumiodonium or azinium) and metal ions (e.g., $Na^+$, $K^+$, $Ca^{2+}$ or $Zn^{2+}$).

The substituted phosphono group described above means a group formed by substituting one or two hydroxy groups of a phosphono group with one or two other organic oxy groups. Preferred examples of the substituted phosphono group include a dialkylphosphono group, a diarylphosphono group, an alkylarylphosphono group, a monoalkylphosphono group and a monoarylphosphono group as described above. Of the substituted phosphono groups, a dialkylphosphono group and a diarylphosphono group are more preferred. Specific examples of the substituted phosphono group include diethylphosphono, dibutylphosphono and diphenylphosphono groups.

The phosphonato group ($-PO_3^{2-}$ or $-PO_3H^-$) described above means a conjugate base anion group of a phosphono group ($-PO_3H_2$) resulting from primary acid dissociation or secondary acid dissociation as described above. Ordinarily, it is preferred to use together with a counter cation. Examples of the counter cation include those conventionally known, for example, various oniums (e.g., ammonium, sulfonium, phosphonium iodonium or azinium) and metal ions (e.g., $Na^+$, $K^+$, $Ca^{2+}$ or $Zn^{2+}$).

The substituted phosphonato group described above means a conjugate base anion group of a group formed by substituting one hydroxy group of a phosphono group with another organic oxy group. Specific examples of the substituted phosphonato group include a conjugate base group of a monoalkylphosphono group ($-PO_3H$(alkyl)) and a conjugate base group of a monoarylphosphono group ($-PO_3H$(aryl)). Ordinarily, it is preferred to use together with a counter cation. Examples of the counter cation include those conventionally known, for example, various oniums (e.g., ammonium, sulfonium, phosphonium iodonium or azinium) and metal ions (e.g., $Na^+$, $K^+$, $Ca^{2+}$ or $Zn^{2+}$).

Now, the cyclic structure formed by combining $X^1$ and $X^2$, $R^a$ and $R^b$, or $X^1$ and $R^a$ or $R^b$ with each other is described below. An aliphatic ring formed by combining $X^1$ and $X^2$, $R^a$ and $R^b$, or $X^1$ and $R^a$ or $R^b$ with each other includes a 5-membered, 6-membered, 7-membered and 8-membered aliphatic rings, and preferably a 5-membered and 6-membered aliphatic rings. The aliphatic ring may have one or more substituents (examples thereof include the substituents for the substituted alkyl group described above) on one or more carbon atoms forming the ring. Also, a part of the ring-forming carbon atoms may be replaced by hetero atom(s) (examples thereof include an oxygen atom, a sulfur atom and a nitrogen atom). Further, a part of the aliphatic ring may also form a part of an aromatic ring.

Specific examples of the compound having a structure represented by formula (I) are set forth below, but the present invention should not be construed as being limited thereto.

<u>i) Monofunctional Type</u>

Group A

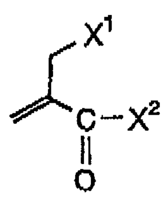

TABLE 1

| No. | $X^1$ | $X^2$ |
|---|---|---|
| A-1 | OH | $OCH_3$ |
| A-2 | OH | $O(n)C_4H_9$ |
| A-3 | OH | $O(n)C_{12}H_{25}$ |
| A-4 | OH | 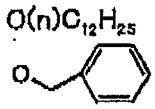 |
| A-5 | OH | 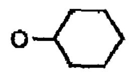 |
| A-6 | OH | 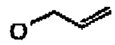 |
| A-7 | OH | 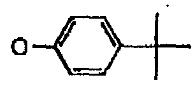 |
| A-8 | $OCH_3$ | $OC_2H_5$ |
| A-9 | 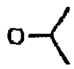 | $O(n)C_4H_9$ |
| A-10 | $O(n)C_8H_{17}$ | $OCH_3$ |
| A-11 | 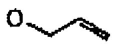 | 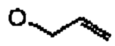 |
| A-12 | 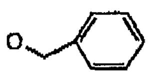 | $OCH_3$ |
| A-13 | 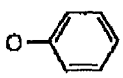 | $OCH_3$ |
| A-14 | 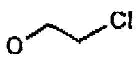 | $OCH_3$ |
| A-15 | 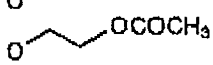 | $OC_2H_5$ |
| A-16 | 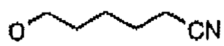 | $OC_2H_5$ |
| A-17 | $OCOCH_3$ | $OCH_3$ |
| A-18 | $OCO(n)C_6H_{13}$ | $OCH_3$ |
| A-19 | 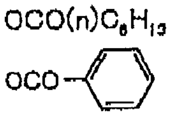 | $OCH_3$ |
| A-20 | $OSO_2CH_3$ | $OCH_3$ |
| A-21 | $OSO_2(n)C_4H_9$ | $OCH_3$ |

TABLE 1 (cont'd)

| No. | $X^1$ | $X^2$ |
|---|---|---|
| A-22 | 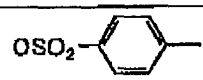 | $OCH_3$ |
| A-23 | $OSO_2CF_3$ | $OC_2H_5$ |
| A-24 | $SCH_3$ | $OC_2H_5$ |
| A-25 | $S(n)C_4H_9$ | $OC_2H_5$ |
| A-26 | 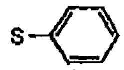 | $OC_2H_5$ |
| A-27 | 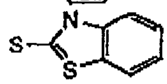 | $OCH_3$ |
| A-28 | 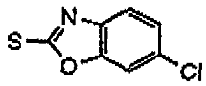 | $OCH_3$ |
| A-29 | F | $O(n)C_{12}H_{25}$ |
| A-30 | F | 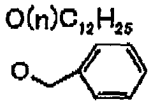 |
| A-31 | Cl | $OCH_3$ |
| A-32 | Cl | 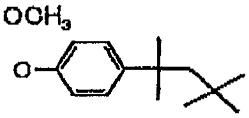 |
| A-33 | Br | $O(n)C_4H_9$ |
| A-34 | Br | 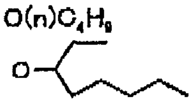 |
| A-35 | I | $O(n)C_4H_9$ |
| A-36 | I | 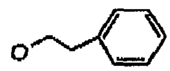 |
| A-37 | 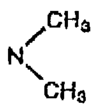 | $OC_2H_5$ |
| A-38 | 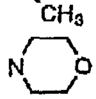 | $OC_2H_5$ |
| A-39 | 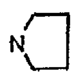 | $OC_2H_5$ |
| A-40 | 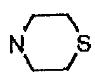 | $OC_2H_5$ |
| A-41 | 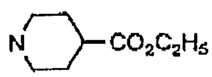 | $OC_2H_5$ |
| A-42 | 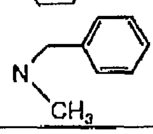 | $OC_2H_5$ |

TABLE 1 (cont'd)

| No. | $X^1$ | $X^2$ |
|---|---|---|
| A-43 | 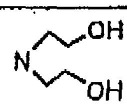 | $OC_2H_5$ |
| A-44 | 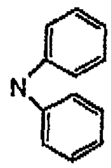 | $OC_2H_5$ |
| A-45 | 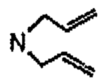 | $OC_2H_5$ |
| A-46 | $NHCOCH_3$ | $OCH_3$ |
| A-47 | $NHCO(n)C_4H_9$ | $O(n)C_4H_9$ |
| A-48 | 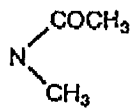 | $OCH_3$ |
| A-49 | $NHSO_2CH_3$ | $O(n)C_4H_9$ |
| A-50 | 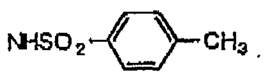 | $O(n)C_4H_9$ |
| A-51 | $OCOCH_3$ | 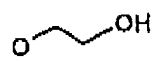 |
| A-52 | $OCOCH_3$ | 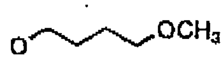 |
| A-53 | $OCOCH_3$ | 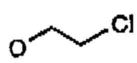 |
| A-54 | $OCOCH_3$ | 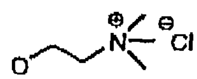 |
| A-55 | $OCOCH_3$ | 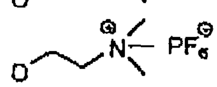 |
| A-56 | $OCOC_2H_5$ | 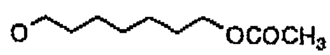 |
| A-57 | $OCOC_2H_5$ | 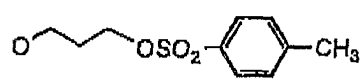 |
| A-58 | $OCOC_2H_5$ | 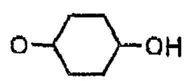 |
| A-60 | 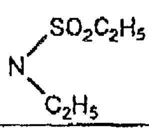 | $OCH_3$ |

TABLE 1 (cont'd)

| No. | $X^1$ | $X^2$ |
|---|---|---|
| A–70 | $OCOCH_3$ | 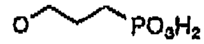 |
| A–71 | $OCOCH_3$ | 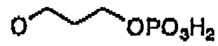 |
| A–72 | $OCOCH_3$ | 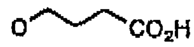 |
| A–73 | 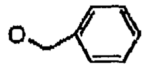 | OH |
| A–74 | 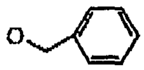 | $O^{\ominus}Na^{\oplus}$ |
| A–75 | 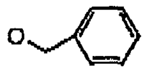 | 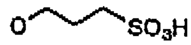 |
| A–76 | 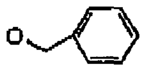 | 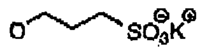 |
| A–77 | 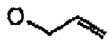 | 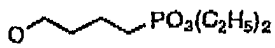 |
| A–78 | 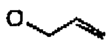 | 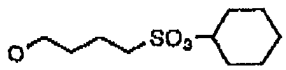 |
| A–79 | OH | $OC_2H_5$ |
| A–80 | 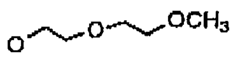 | $OCH_3$ |
| A–81 | 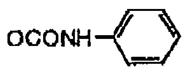 | $OCH_3$ |
| A–82 | 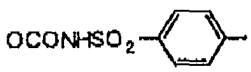 | $OCH_3$ |
| A–83 | 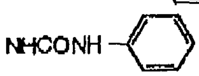 | $OCH_3$ |
| A–84 | $NHCO_2(n)C_6H_{13}$ | $OCH_3$ |
| A–85 | $OCSNH(n)C_4H_9$ | $OCH_3$ |

Group B

TABLE 2

| | |
|---|---|
| B-1 | 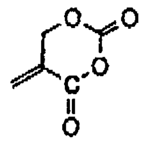 |
| B-2 | 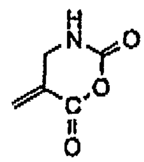 |
| B-3 | 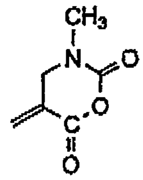 |
| B-4 | 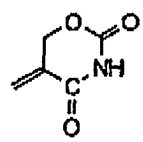 |
| B-5 | 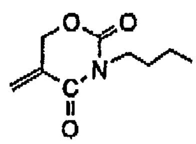 |
| B-6 | 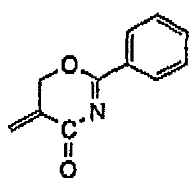 |
| B-7 | 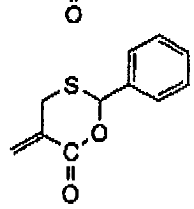 |
| B-8 | 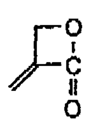 |
| B-9 | 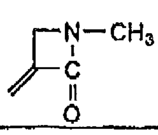 |

ii) Difunctional Type

Group C

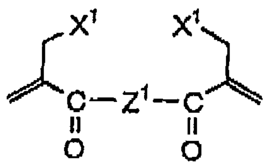

TABLE 3

| No. | $X^1$ | $Z^1$ |
|---|---|---|
| C-1 | OH | 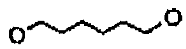 |
| C-2 | OH | 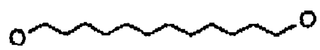 |
| C-3 | $OCOCH_3$ | 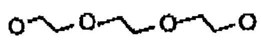 |
| C-4 | $OCOCH_3$ | 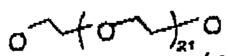 (average number) |
| C-5 | OH | 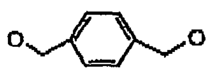 |
| C-6 | OH | 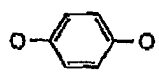 |
| C-7 | OH | 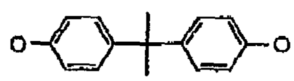 |
| C-8 | OH | 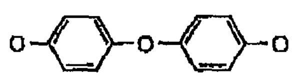 |
| C-9 | $OCH_3$ | 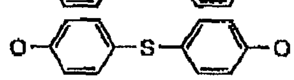 |
| C-10 | 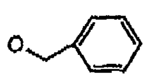 | 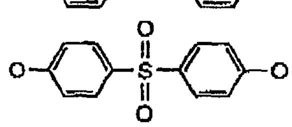 |
| C-11 | $OCOC_2H_5$ | 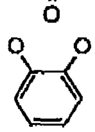 |
| C-12 | $OCOC_2H_5$ | 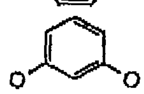 |
| C-13 | OH | 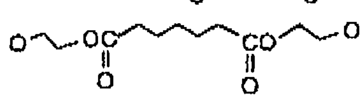 |
| C-14 | $OCOCH_3$ | 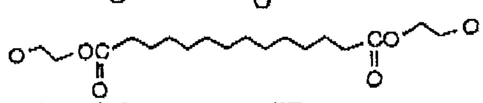 |

TABLE 3 (cont'd)

| No. | $X^1$ | $Z^1$ |
|---|---|---|
| C-15 | 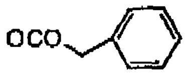 | 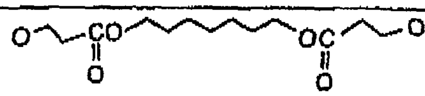 |
| C-16 | OH | 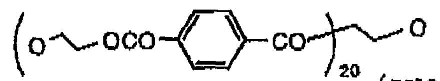 (average number) |
| C-17 | OH | 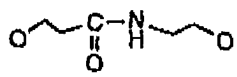 |
| C-18 | OH | 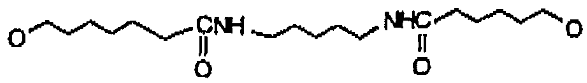 |
| C-19 | $OCOCH_3$ | 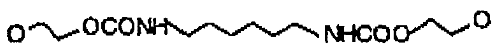 |
| C-20 | $OCOCH_3$ | 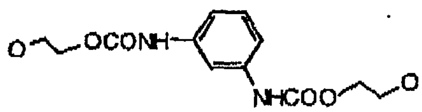 |
| C-21 | OCO(n)Pr | 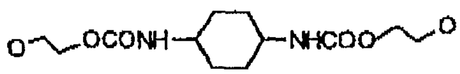 |
| C-22 | OCO(n)Pr | 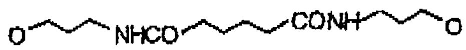 |
| C-23 | 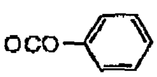 | 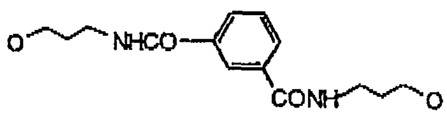 |
| C-24 | $SCH_3$ | 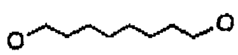 |
| C-25 | 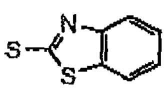 | 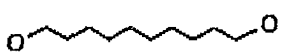 |
| C-26 | $SCOCH_3$ | 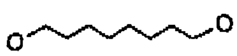 |
| C-27 | $OSO_2CH_3$ | 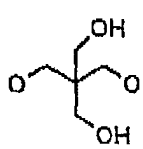 |
| C-28 | 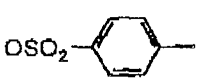 | 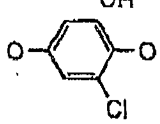 |
| C-29 | 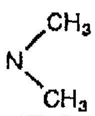 | 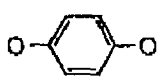 |

TABLE 3 (cont'd)

| No. | $X^1$ | $Z^1$ |
|---|---|---|
| C-30 | 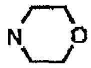 | 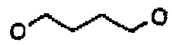 |
| C-31 | 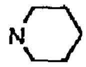 | 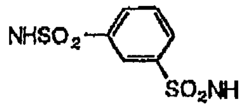 |
| C-32 | F | 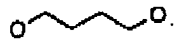 |
| C-33 | $NHCOCH_3$ | 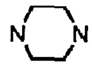 |
| C-34 | 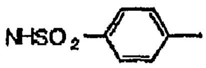 | 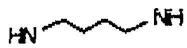 |
| C-35 | 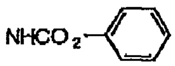 | 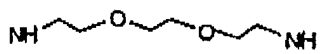 |

Group D

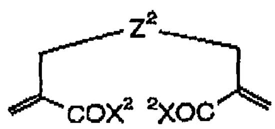

TABLE 4

| No. | $X^2$ | $Z^2$ |
|---|---|---|
| D-1 | $OCH_3$ | 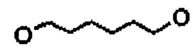 |
| D-2 | $OCH_3$ | 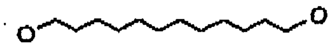 |
| D-3 | $OC_2H_5$ | 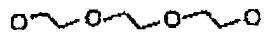 |
| D-4 | $OC_2H_5$ | 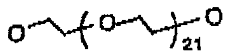 (average number) |
| D-5 | 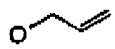 | 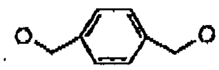 |
| D-6 | 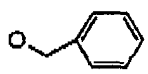 | 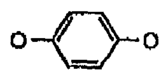 |
| D-7 | $OCH_3$ | 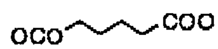 |
| D-8 | $OCH_3$ | 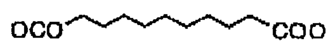 |
| D-9 | $O(n)C_4H_9$ | 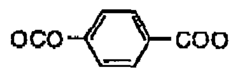 |
| D-10 | $O(n)C_4H_9$ | 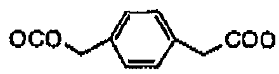 |
| D-11 | 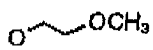 | 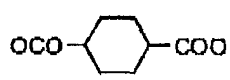 |
| D-12 | 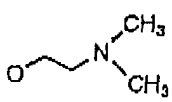 | 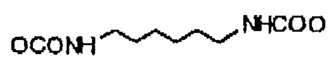 |
| D-13 | $OCH_3$ | 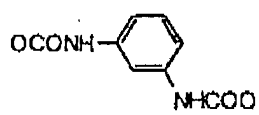 |
| D-14 | $OCH_3$ | 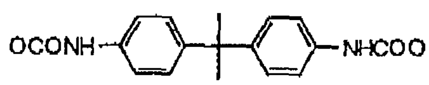 |

TABLE 4 (cont'd)

| No. | $X^2$ | $Z^2$ |
|---|---|---|
| D-15 | $OCH_3$ | 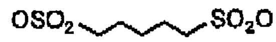 |
| D-16 | $O(n)C_{12}H_{25}$ | 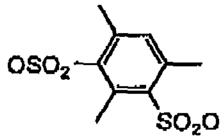 |
| D-17 | $OCH_3$ | 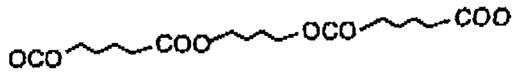 |
| D-18 | $OCH_3$ | 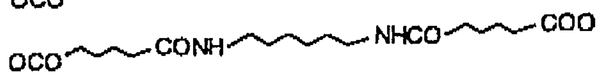 |
| D-19 | $OCH_3$ | 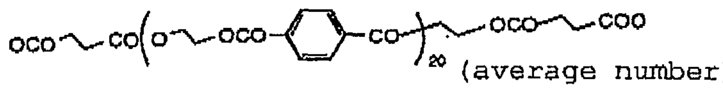 (average number) |
| D-20 | $OC_2H_5$ | 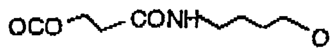 |
| D-21 | $OCH_3$ | 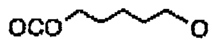 |
| D-22 | $SCH_3$ | 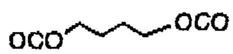 |
| D-23 | 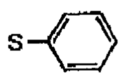 | 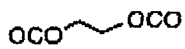 |
| D-24 | 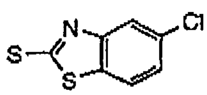 | 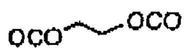 |
| D-25 | 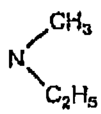 | 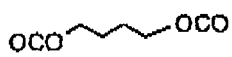 |
| D-26 | 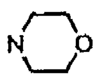 | 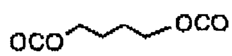 |
| D-27 | $NH(n)C_{12}H_{25}$ | 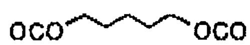 |
| D-28 | $OCH_3$ | 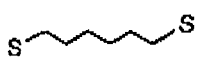 |
| D-29 | 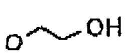 | 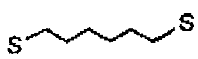 |
| D-30 | 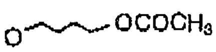 | 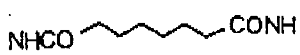 |

TABLE 4 (cont'd)

| No. | $X^2$ | $Z^2$ |
|---|---|---|
| D-31 | $OCH_3$ | 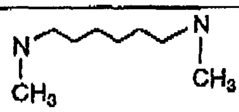 |
| D-32 | $OCH_3$ | 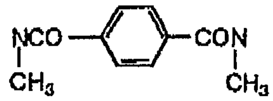 |
| D-33 | $OCH_3$ | 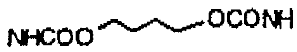 |
| D-34 | $OCH_3$ | 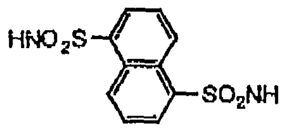 |
| D-35 | $OC_2H_5$ | O |

iii) Trifunctional or More Type

Group E

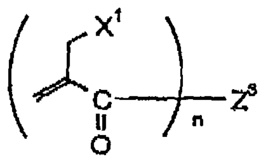

(n≧3)

TABLE 5

| No. | $X^1$ | $Z^3$ |
|---|---|---|
| E-1 | OH | 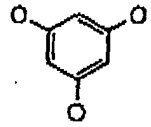 |
| E-2 | $OCH_3$ | 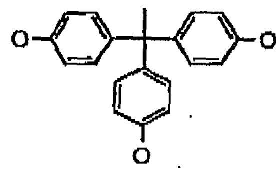 |
| E-3 | $OCOCH_3$ | 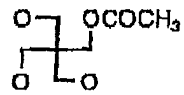 |
| E-4 | OH | 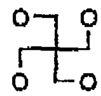 |
| E-5 | $OCOCH_3$ | 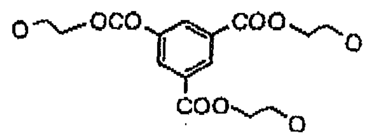 |
| E-6 | 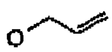 | 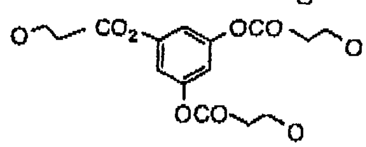 |
| E-7 | OH | 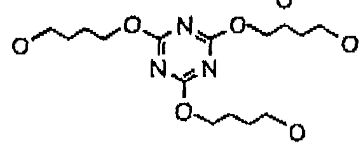 |
| E-8 | OH | 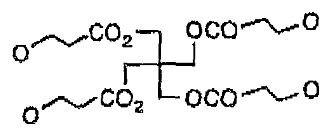 |
| E-9 | OH | 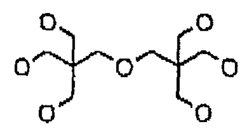 |

TABLE 5 (cont'd)

| No. | $X^1$ | $Z^3$ |
|---|---|---|
| E-10 | $OCOCH_3$ | 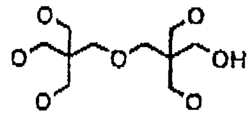 |
| E-11 | $SCH_3$ | 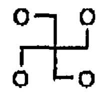 |
| E-12 | Cl | 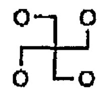 |
| E-13 | Br | 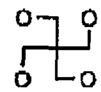 |
| E-14 | 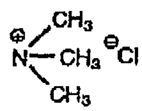 | 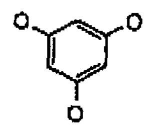 |
| E-15 | 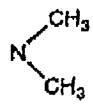 | 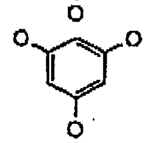 |
| E-16 | 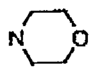 | 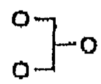 |
| E-17 | $OCO(n)C_{12}H_{25}$ | 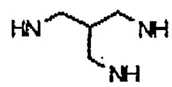 |
| E-18 | 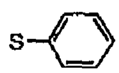 | 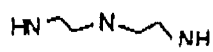 |
| E-19 | 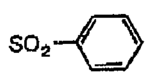 | 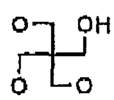 |
| E-20 | 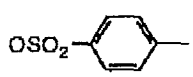 | 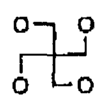 |
| E-21 | $NHCOCH_3$ | 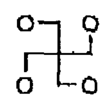 |
| E-22 | 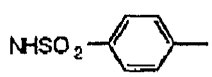 | 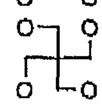 |

TABLE 5 (cont'd)

| No. | $X^1$ | $Z^3$ |
|---|---|---|
| E-23 | 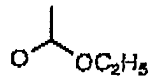 | 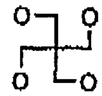 |
| E-24 | 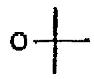 | 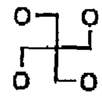 |
| E-25 | OH | 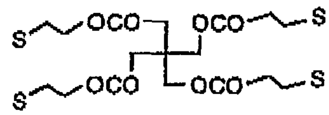 |
| E-26 | OH | 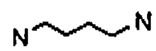 |

Group F

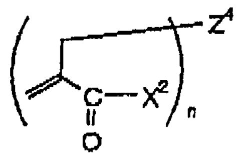

$(n \geqq 3)$

TABLE 6

| No. | $X^2$ | $Z^4$ |
|---|---|---|
| F-1 | OH | 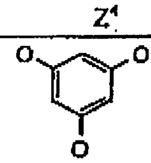 |
| F-2 | $OCH_3$ | 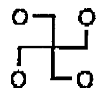 |
| F-3 | $OCH_3$ | 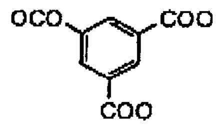 |
| F-4 | $OCH_3$ | 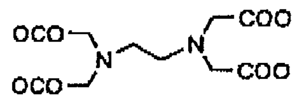 |
| F-5 | $OC_2H_5$ | 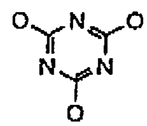 |
| F-6 | $OCH_3$ | 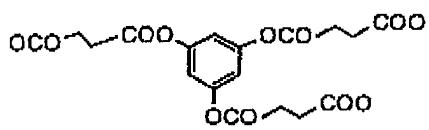 |
| F-7 | $OCH_3$ | 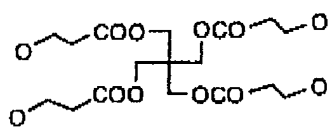 |
| F-8 | $O(n)C_3H_7$ | 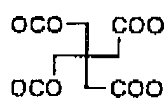 |
| F-9 | 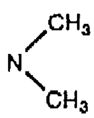 | 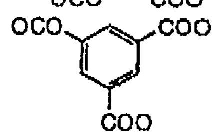 |
| F-10 | $O(n)C_{12}H_{25}$ | 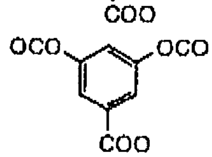 |

TABLE 6 (cont'd)

| No. | $X^2$ | $Z^1$ |
|---|---|---|
| F-11 | 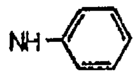 | 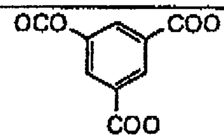 |
| F-12 | $NH-(n)C_4H_9$ | 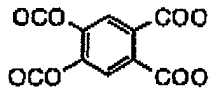 |
| F-13 | Cl | 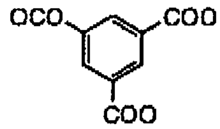 |
| F-14 | $O^{\ominus}Na^{\oplus}$ | 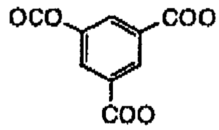 |
| F-15 | 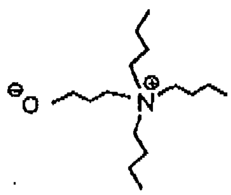 | 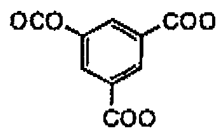 |
| F-16 | $OCH_3$ | 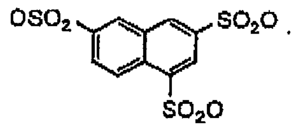 |
| F-17 | $OCH_3$ | 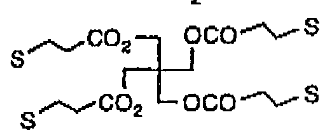 |
| F-18 | $OCH_3$ | 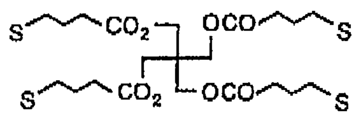 |
| F-19 | 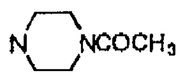 | 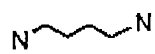 |
| F-20 | 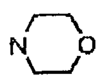 | 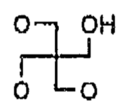 |
| F-21 | $OCH_3$ | 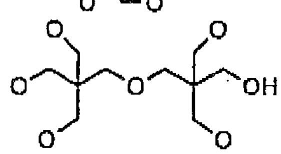 |
| F-22 | 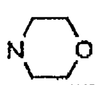 | 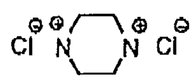 |

iv) Polymer Type

Group G

G-1 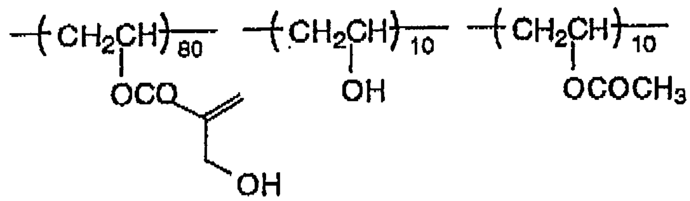 Mw 20000

G-2 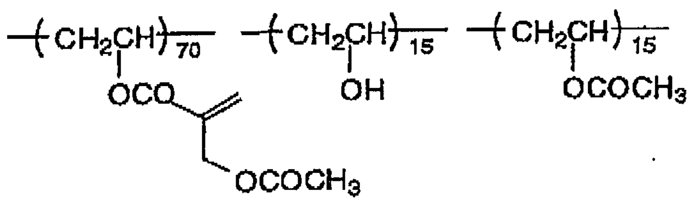 Mw 15000

G-3 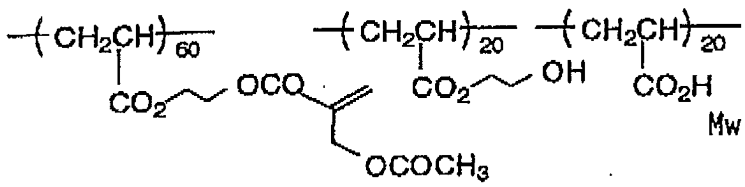 Mw 30000

G-4 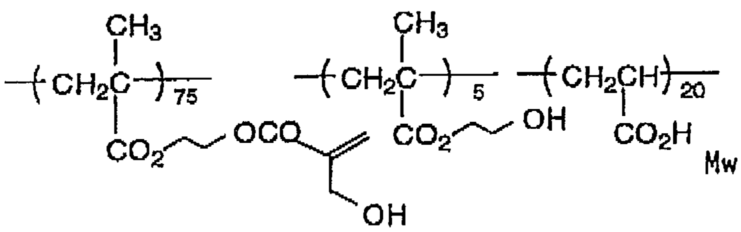 Mw 50000

G-5 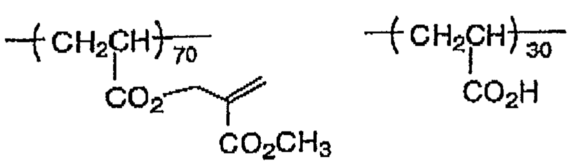 Mw 20000

G-6 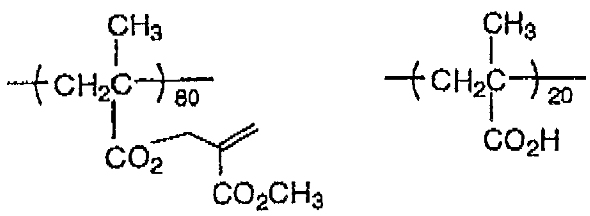 Mw 10000

G-7

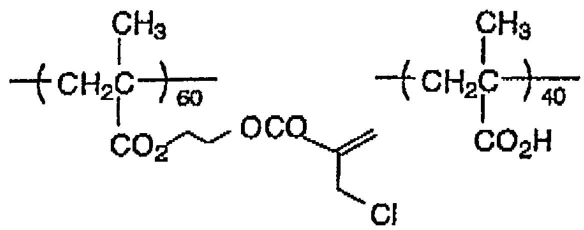

Mw 20000

G-8

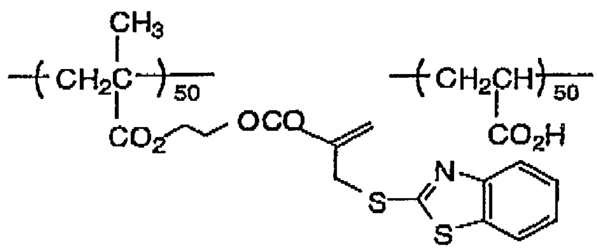

Mw 20000

G-9

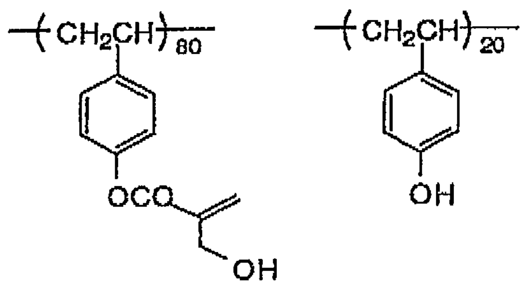

Mw 5000

G-10

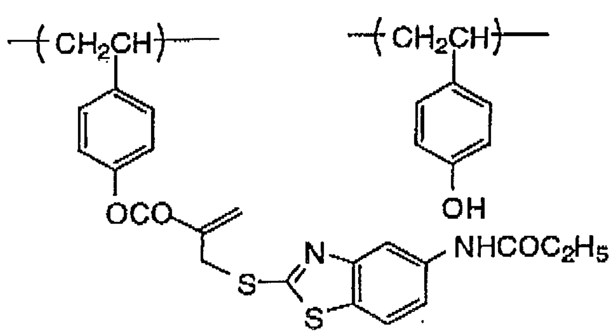

Mw 10000

G-11

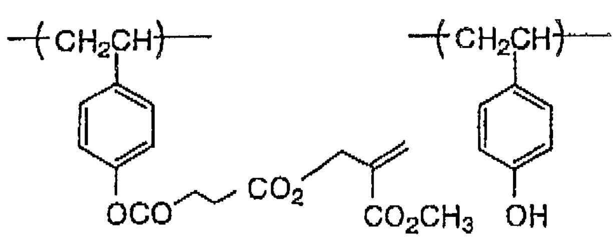

Mw 10000

G-12

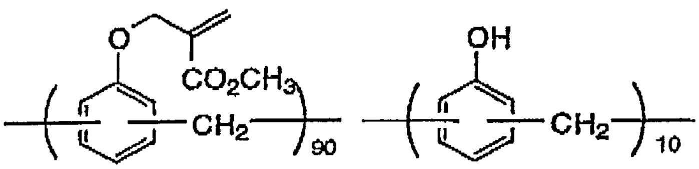

Mw 5000

G-13

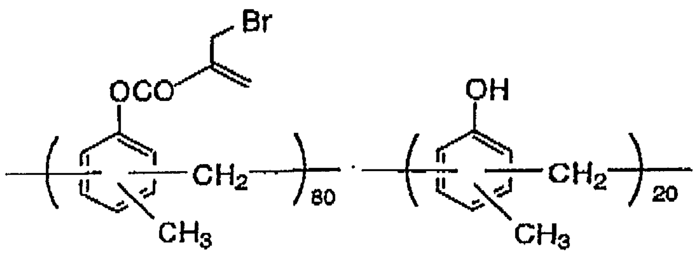

Mw 7500

(m/p=6/4) (m/p=6/4)

G-14

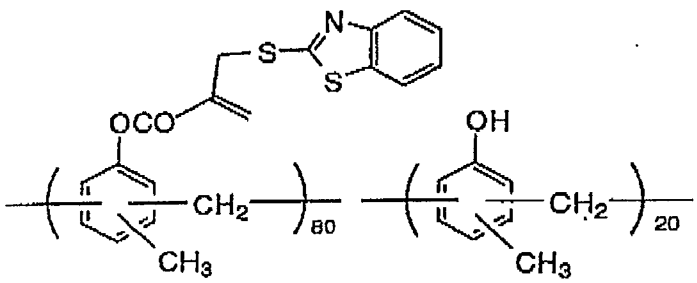

Mw 4000

(m/p=7/3) (m/p=7/3)

G-15

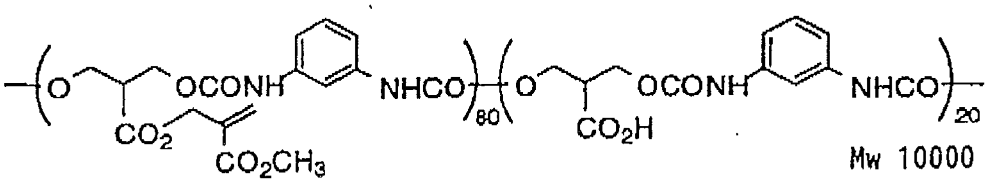

Mw 10000

G-16

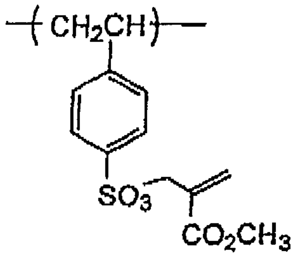

Mw 100000

G-17

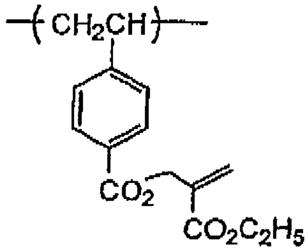

Mw 15000

G-18

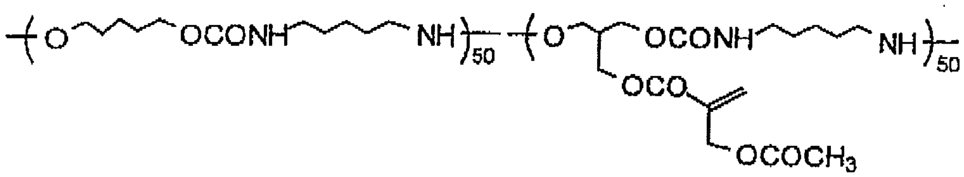

Mw20000

G-19

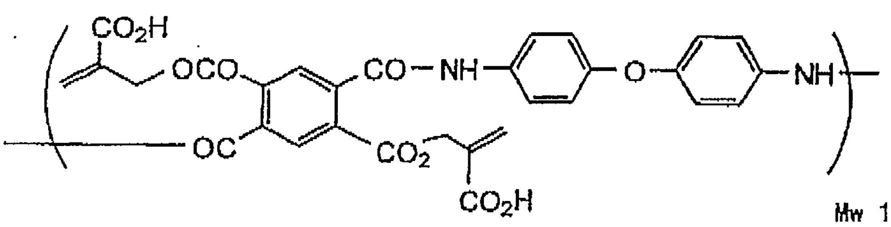

Mw 15000

G-20

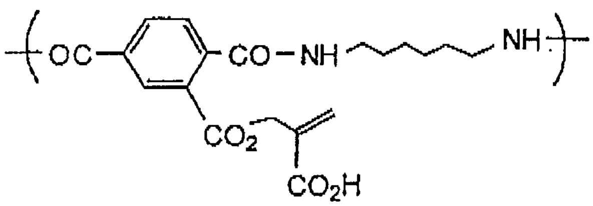

Mw 5000

G-21

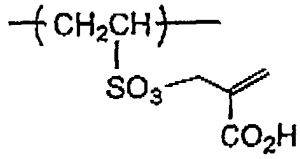

Mw 20000

G-22

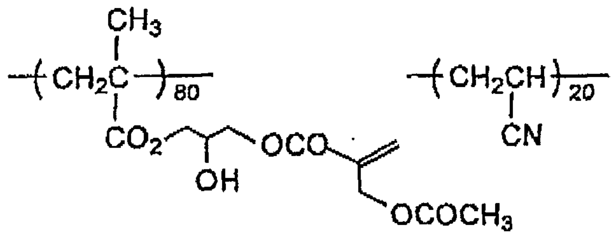

Mw 30000

G-23

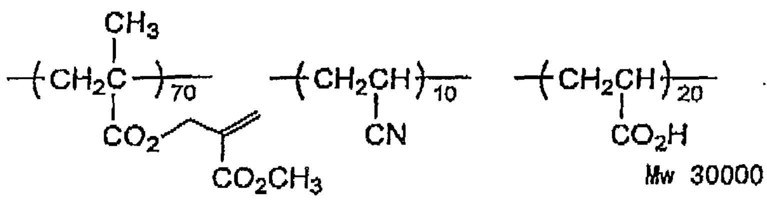

Mw 30000

G-24

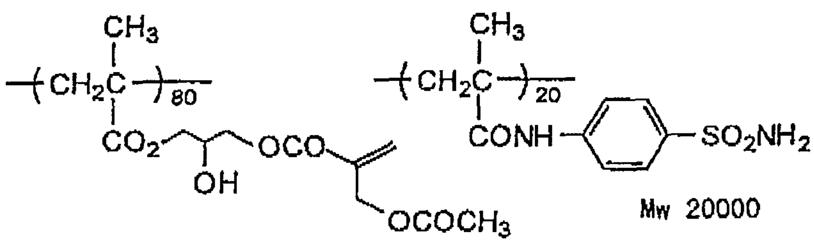

Mw 20000

G-25

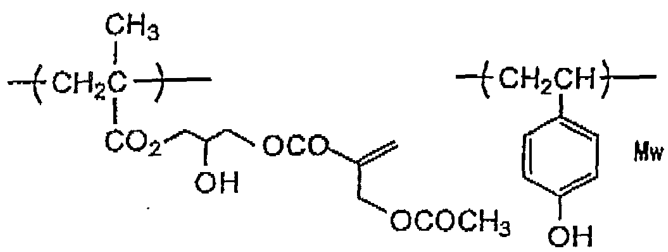

Mw 15000

G-26

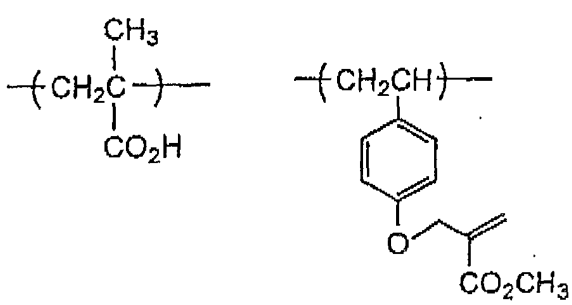

Mw 10000

v) Others

Group H

H-1

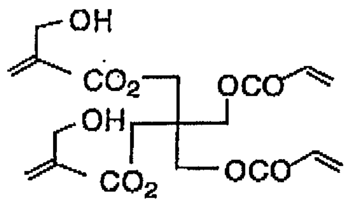

H-2

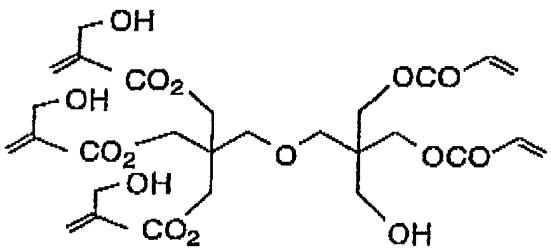

H-3

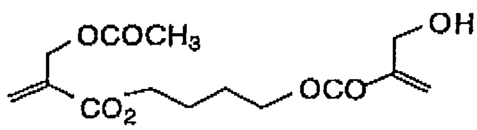

H-4

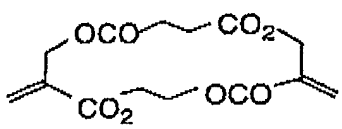

H-5

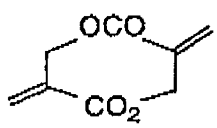

H-6

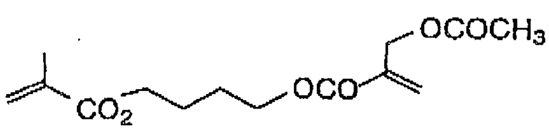

H-7

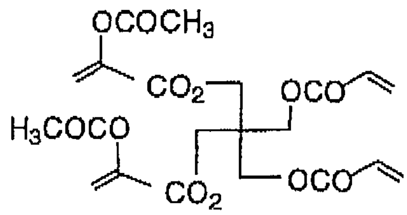

Group J

J-1

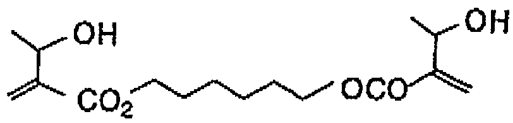

J-2

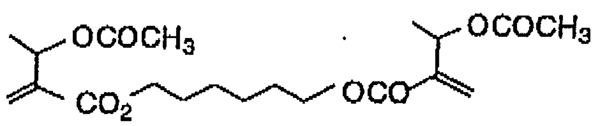

J-3

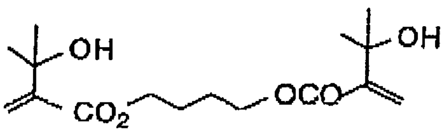

J-4

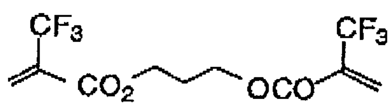

J-5

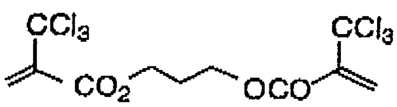

J-6

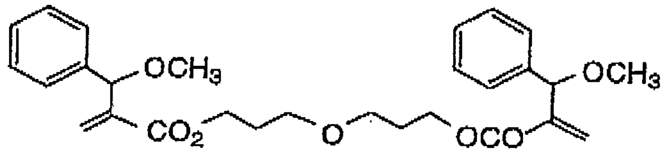

J-7

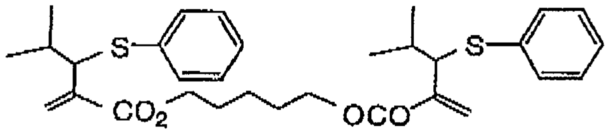

J-8

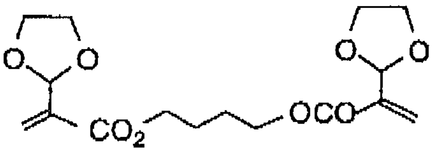

J-9

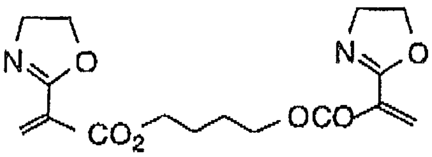

J-10

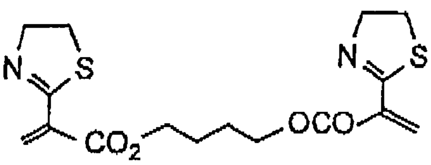

J-11

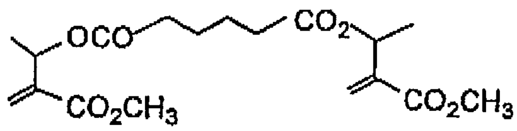

J-12

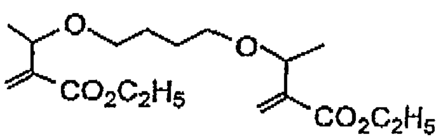

J-13

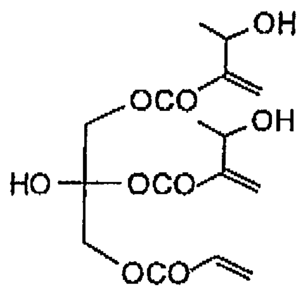

J-14

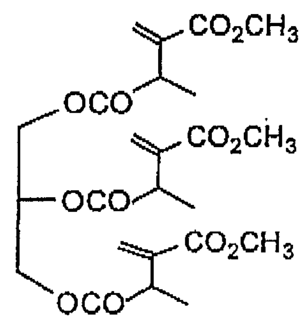

J-15

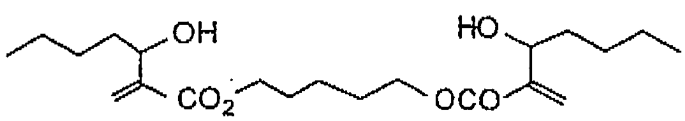

The amount of the ethylenically unsaturated compound to be incorporated in the photosensitive layer is from 30% to 70% by weight, preferably from 35% to 65% by weight, more preferably from 40% to 60% by weight, particularly preferably from 45% to 55% by weight based on the total weight based on the total weight of the components of the photosensitive layer of the photosensitive layer.

The photopolymerization initiator to be incorporated in the photosensitive layer of the photosensitive lithographic printing plate of the invention will be described hereinafter.

The photopolymerization initiator to be incorporated in the photosensitive layer of the photosensitive lithographic printing plate of the invention can be appropriately selected from various known photopolymerization initiators described, for example, in patents or references, and a combination of two or more thereof (photopolymerization initiator system) depending on the wavelength of light source used.

In the case where secondary harmonics of blue semiconductor laser, Ar laser or infrared semiconductor laser or SHG-YAG laser is used as a light source, various photopolymerization initiators (systems) have been proposed. Examples of the photopolymerization initiators (systems) include certain kinds of photo-reducing dyes, for example, Rose Bengale, Eosine or Erythrosine disclosed in U.S. Patent 2,850,445, and systems comprising dye and initiator in combination, for example, composite initiation system comprising dye and amine (Japanese Patent Publication No. 1969-20189), system comprising hexaaryl biimidazole, radical generator and dye in combination (Japanese Patent Publication No. 1970-37377), system comprising hexaaryl biimidazole and p-dialkylaminobenzylidene ketone (Japanese Patent Publication No. 1972-2528, Japanese Patent Laid-Open No. 1979-155292), system comprising cyclic cis-α-dicarbonyl compound and dye (Japanese Patent Laid-Open No. 1983-84183), system comprising cyclic triazine and melocyanine dye (Japanese Patent Laid-Open No. 1979-151024), system comprising 3-ketocoumarine and active agent (Japanese Patent Laid-Open No. 1977-112681, Japanese Patent Laid-Open No. 1983-15503), system comprising biimidazole, styrene derivative and thiol (Japanese Patent Laid-Open No. 1984-140203), system comprising organic

peroxide and dye (Japanese Patent Laid-Open No. 1984-1504, Japanese Patent Laid-Open No. 1984-140203, Japanese Patent Laid-Open No. 1984-189340, Japanese Patent Laid-Open No. 1987-174203, Japanese Patent Publication No. 1987-1641, U.S. Patent 4,766,055), system comprising dye and active halogen compound (Japanese Patent Laid-Open No. 1988-1718105, Japanese Patent Laid-Open No. 1988-258903, Japanese Patent Laid-Open No. 1990-63054), system comprising dye and borate compound (Japanese Patent Laid-Open No. 1987-143044, Japanese Patent Laid-Open No. 1987-150242, Japanese Patent Laid-Open No. 1989-13140, Japanese Patent Laid-Open No. 1989-13141, Japanese Patent Laid-Open No. 1989-13142, Japanese Patent Laid-Open No. 1989-13143, Japanese Patent Laid-Open No. 1989-13144, Japanese Patent Laid-Open No. 1989-17048, Japanese Patent Laid-Open No. 1989-229003, Japanese Patent Laid-Open No. 1989-298348, Japanese Patent Laid-Open No. 1989-138204), system comprising dye having rhodanine ring and radical generator (Japanese Patent Laid-Open No. 1990-179643, Japanese Patent Laid-Open No. 1990-244050), system comprising titanocene and 3-ketocoumarine dye (Japanese Patent Laid-Open No. 1988-221110), system comprising titanocene, xanthene dye and addition-polymerizable ethylenically unsaturated compound containing amino group or urethane group (Japanese Patent Laid-Open No. 1992-221958, Japanese Patent Laid-Open No. 1992-219756), system comprising titanocene and specific melocyanine dye (Japanese Patent Laid-Open No. 1994-295061) and system comprising titanocene and dye having benzopyrane ring (Japanese Patent Laid-Open No. 1994-334897).

A particularly preferred photopolymerization initiator (system) to be incorporated in the photosensitive layer of the photopolymerizable lithographic printing plate of the invention contains at least one titanocene.

The titanocene compound to be used as a photopolymerization initiator (system) in the invention is not particularly limited so far as it can generate active radicals when irradiated with light in the presence of other sensitizing dyes. For example, known compounds disclosed in Japanese Patent Laid-Open No. 1984-152396, Japanese Patent Laid-Open No. 1986-151197, Japanese Patent Laid-Open No. 1988-41483, Japanese Patent Laid-Open No. 1988-41484, Japanese Patent Laid-Open No. 1990-249, Japanese Patent Laid-Open No. 1990-291, Japanese Patent Laid-Open No. 1992-27393, Japanese Patent Laid-Open No. 1992-12403, and Japanese Patent Laid-Open No. 1994-41170 are appropriately selected to use.

Specific examples of the titanocene compound include di-cyclopentadienyl-Ti-di-chloride, di-cyclopentadienyl-Ti-bis-phenyl, di-cyclopentadienyl-Ti-bis-2,3,4,5,6-pentafluorophen-1-yl, (hereinafter also referred to as "T-1"), di-cyclopentadienyl-Ti-bis-2,3,5,6-tetrafluorophen-1-yl, di-cyclopentadienyl-Ti-bis-2,4,6-trifluorophen-1-yl, di-cylopentadienyl-Ti-bis-2,6-diflorophen-1-yl, di-cyclopentadienyl-Ti-bis-2,4-difluorophen-1-yl, di-methylcyclopentadienyl-Ti-bis-2,3,4,5,6-pentafluorophen-1-yl, di-methylcylopentadienyl-Ti-bis-2,3,5,6-tetrafluoropen-1-yl, di-methylcyclopentadienyl-Ti- bis-2,4-difluorophen-1-yl, and bis (cyclopentadienyl)-bis(2,6-difluoro-3-(pil-1-il)phenyl)titanium (hereinafter also referred to as "T-2").

The titanocene compounds may be further subjected to various chemical modifications for improving the properties of the photosensitive layer. For example, bonding to sensitizing dye, addition-polymerizable unsaturated compound or other radical-generating parts, introduction of hydrophilic moiety, introduction of substituent for improving compatibility or inhibiting deposition of crystal, or introduction of substituent or polymerization for improving adhesion may be utilized.

The use of the titanocene compounds may be appropriately determined according to the design of the properties of the photopolymerizable lithographic printing plate similarly to the aforementioned addition-polymerizable compound. For example, the use of two or more of the titanocene compounds in combination makes it possible to enhance the compatibility thereof with the photosensitive layer.

The amount of photopolymerization initiator used is from 3.0 to 45% by weight, preferably from 5.0 to 40% by weight, more preferably from 10 to 35% by weight, and particularly preferably from 15 to 30% by weight based on the total component of photosensitive layer. When the amount is less than 3.0% by weight, the sufficient sensitivity may not be obtained, whereas when it is more than 45% by weight, development scum may occur.

The photosensitive layer of the photopolymerizable lithographic printing plate of the invention may contain a co-sensitizer in combination with the aforementioned photopolymerization initiator to further the sensitivity thereof. The mechanisms of action are not completely clear, but most of them are considered to be based on the following chemical process. Specifically, various intermediate active species (radical, peroxide, oxide, reducing agent, etc.) produced during the photoreaction initiated by the light absorption by the aforementioned photopolymerization initiator (system) and the successive addition polymerization react with the co-sensitizer to produce new active radicals. The co-sensitizers are roughly classified into (a) co-sensitizer which can be reduced to produce active radical, (b) co-sensitizer which can be oxidized to produce active radical, and (c) co-sensitizer which can react with a radical having a low activity to convert it to a radical having a higher activity or act as a chain transfer agent. In most cases, there are no common beliefs on to which group individual compounds belong.

(a) Compound which is reduced to produce active radical

Compound having carbon-halogen bond: It is believed that the compound undergoes cleavage of carbon-halogen bond upon reduction to produce active radical. Specifically, trihalomethyl-s-triazines, trihalomethyloxadiazoles, etc. are preferably used.
Compound having nitrogen-nitrogen bond: It is believed that the compound undergoes cleavage of nitrogen-nitrogen bond upon reduction to produce active radical. Specifically, hexaaryl biimidazoles, etc. are preferably used.
Compound having oxygen-oxygen bond: It is believed that the compound undergoes cleavage of oxygen-oxygen bond upon reduction to produce active radical. Specifically, organic peroxides, etc. are preferably used.
Onium compound: It is believed that the compound undergoes cleavage of carbon-hetero bond or oxygen-nitrogen bond upon reduction to produce active radical. Specifically, diaryl iodonium salts, triaryl sulfonium salts, N-alkoxypyridinium (azinium) salts, etc. are preferably used.
Ferrocene, iron allene complexes; The compound can produce active radical upon reduction.

(b) Compound which can be oxidized to produce active radicals

Metal ate complex: It is believed that the compound undergoes cleavage of carbon-hetero bond upon oxidation to produce active radical. Specifically, triaryl alkyl borates are preferably used.
Alkylamine compound: It is believed that the compound undergoes cleavage of C-X bond on the carbon atom adjacent to a nitrogen atom upon oxidation to produce active radical. X is preferably a hydrogen atom, carboxy group, trimethylsilyl group, benzyl group or the like. Specific examples of the compound include ethanolamines, N-phenylglycines, and N-trimethylsilylmethylanilines.
Sulfur-containing or tin-containing compound: A compound obtained by substituting the nitrogen atom in the aforementioned amine by sulfur atom or tin atom can produce active radical in a similar manner. A compound having S-S bond is also known to undergo cleavage of the S-S bond to exhibit the sensitization function.
α-Substituted methylcarbonyl compound: The compound can undergo cleavage of carbonyl-α carbon bond upon oxidation to produce active radical. A compound obtained by substituting the carbonyl group in the compound by oxim ether also acts similarly. Specifically, 2-alkyl-1-[4-(alkylthio)phenyl]-2-morpholinopronone-1, and oxim ether obtained by reacting such a compound with a hydroxylamine and then etherifying the N-OH can be used.
Sulfinic acid salts: The compound can produce active radical upon reduction. Specifically, sodium arylsulfinate, etc. can be used.

(c) Compound which can react with a radical having a low activity to convert it to a radical having a higher activity or act as a chain transfer agent:

Examples of the compound include compounds having SH, PH, SiH or GeH in its molecule. The compound denotes hydrogen to a radical species having a low activity to produce radical or undergo oxidation followed by deprotonization to produce radical. Specifically, 2-mercaptobenzimidazoles, etc. may be used.
Specific examples of the co-sensitizers are described as additives for the purpose of enhancing sensitivity in Japanese Patent Laid-Open No. 1997-236913. Some of the co-sensitizers are exemplified below, but those used in the photosensitive layer of the photopolymerizable lithographic printing plate of the invention are not limited thereto.

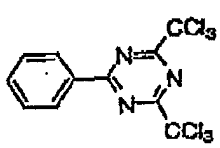
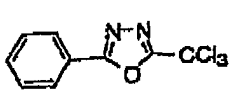
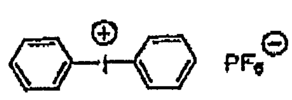
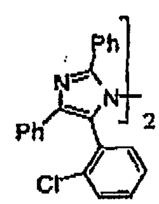

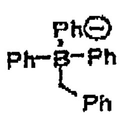
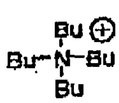
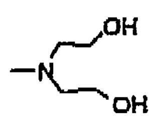
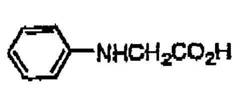
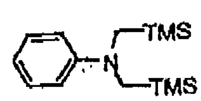

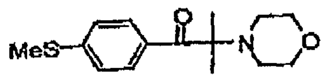 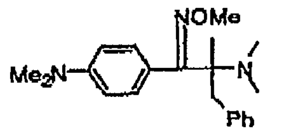 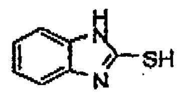

The co-sensitizer can also be subjected to various chemical modifications for improving the properties of the photosensitive layer. For example, bonding to sensitizing dye, titanocene, addition-polymerizable unsaturated compound or other radical-generating parts, introduction of hydrophilic moiety, introduction of substituent for improving compatibility or inhibiting deposition of crystal, or introduction of substituent or polymerization for improving adhesion may be utilized.

The co-sensitizers may be used singly or in combination of two or more thereof. The amount of co-sensitizer used is suitably from 0.05 to 100 parts by weight, preferably from 1 to 80 parts by weight, and more preferably from 3 to 50 parts by weight based on 100 parts by weight of the compound having an ethylenically unsaturated double bond.

An organic polymer, which is soluble or swellable in an aqueous alkali is employed as the polymer binder for use in the photosensitive layer of photopolymerizable lithographic printing plate of the invention, because not only the polymer binder acts as a film-forming material for the photosensitive layer but also it needs to be dissolved in an alkali developer.

When a water-soluble organic polymer is used as the organic polymer, aqueous development is made possible. Examples of the water-soluble organic polymer include addition polymer having carboxylic acid group in its side chain as disclosed in Japanese Patent Laid-Open No. 1984-44615, Japanese Patent Publication No. 1979-34327, Japanese Patent Publication No. 1983-12577, Japanese Patent Publication No. 1979-25957, Japanese Patent Laid-Open No. 1979-92723, Japanese Patent Laid-Open No. 1984-53836 and Japanese Patent Laid-Open No. 1984-71048, for example, methacrylic acid copolymer, acrylic acid copolymer, itaconic acid copolymer, crotonic acid copolymer, maleic acid copolymer and partly esterified maleic acid copolymer.

Similarly, acidic cellulose derivative having carboxylic acid group in its side chain may be used. Further, compound obtained by adding cyclic acid anhyride to addition polymer having hydroxyl group is useful. Particularly, [benzyl (meth)arylate/(meth)acrylic acid/optionally other addition-polymerizable vinyl monomers]copolymer and [allyl [meth] acrylate/(meth)acrylic acid/optionally other addition-polymerizable vinyl monomers]copolymer are preferred. In addition, polyvinyl pyrrolidone, polyethylene oxide, etc. are useful as water-soluble organic polymer. In order to enhance the strength of hardened film, alcohol-soluble polymaide, polyether of 2,2-bis-(4-hydroxyphenyl)-propane with epichlorohydrin, etc. can be used.

Further, polyurethane resins disclosed in Japanese Patent Publication No. 1995-120040, Japanese Patent Publication No. 1995-120041, Japanese Patent Publication No. 1995-120042, Japanese Patent Publication No. 1996-12424, Japanese Patent Laid-Open No. 1988-287944, Japanese Patent Laid-Open No. 1988-287947, Japanese Patent Laid-Open No. 1989-271741 and Japanese Patent Laid-Open No. 1999-352691 are useful for the purpose of the invention.

The polymer may have a functional group, for example, an addition polymerizable group, incorporated into its side chain to enhance the strength of the hardened film.

Examples of the addition polymerizable group include ethylenically unsaturated bond group, amino group, and epoxy group. Examples of the functional group, which can become a radical when irradiated with light, include mercapto group, thiol group, halogen atom, triazine structure, and onium salt structure. Examples of the polar group include carboxy group, and imido group. Particularly preferred examples of the functional group, which can undergo addition polymerization reaction, include ethylenically unsaturated bond groups, for example, acryl group, methacryl group, allyl group or styryl group. Further, functional groups selected from amino group, hydroxy group, phosphonic acid group, phosphoric acid group, carbamoyl group, isocyanate group, ureido group, ureilene group, sulfonic acid group and ammonio group.

In order to maintain the developability of the composition of the invention, the polymer binder of the invention preferably has a proper molecular weight and acid value. Specifically, a polymer having a weight average molecular weight of from 5,000 to 300,000 and an acid value of from 20 to 200 mgKOH/g can be effectively used.

The organic polymer may be incorporated in the composition in an appropriate amount. However, when the content of organic polymer exceeds 70% by weight, no good results can be given in view of intensity of the resulting image. The content of organic polymer is preferably from 10 to 60% by weight, more preferably from 15 to 55% by weight.

The composition of the invention may further comprise a coloring agent beside the aforementioned basic components for the purpose of coloring the photosensitive layer. Examples of the coloring agent include pigments, for example, phthalocyanine pigment (C. I. Pigment Blue 15 : 3, 15 : 4, 15 : 6, etc.), azo pigment, carbon black or titanium oxide, Ethyl Violet, Crystal Violet, azo dye, anthraquinone dye, and cyanine dye. Particularly preferred coloring agents

are metal phthalocyanine pigments from the standpoint of visibility and stability. The amount of dye or pigment added is preferably from about 0.5 to 20% of the total amount of the composition.

The composition of the invention may further comprise a small amount of a thermal polymerization inhibitor during the preparation or storage of the composition for photosensitive layer to inhibit undesirable thermal polymerization of the polymerizable ethylenically unsaturated compound.

Specific examples of the thermal polymerization inhibitor include hydroquinone, p-methoxyphenol, di-tert-butyl-p-cresol, pyrogallol, tert-butyl catechol, benzoquinone, 4,4'-thiobis(3-methyl-6-tert-butyl phenol), 2,2'-methylenebis(4-methyl-6-tert-butylphenol), cerous salt of N-nitrosophenylhydroxylamine, and aluminum salt of N-nitrosophenylhydroxylamine. The amount of the thermal polymerization inhibitor added is preferably from about 0.01 to about 5% by weight based on the total amount of the composition. In order to prevent the polymerization inhibition by oxygen, a higher aliphatic acid derivative such as behenic acid and behenic acid amide may be added so that it is maldistributed on the surface of the photosensitive layer during the drying step after coating. The amount of higher aliphatic acid derivative added is preferably from about 0.5 to about 10% by weight of the total weight of the composition.

In addition, additives, for example, inorganic filler or plasticizer, e.g., dioctyl phthalate, dimethyl phthalate or tricresyl phosphate may be added to improve the physical properties of hardened film. The amount of additive added is preferably not greater than 10% by weight of the total weight of the composition.

The photosensitive layer composition for the photopolymerizable lithographic printing plate of the invention is dissolved in various organic solvents before being applied to a support described below. Examples of the solvent used include acetone, methyl ethyl ketone, cyclohexane, ethyl acetate, ethylene dichloride, tetrahydrofurane, toluene, ethylene glycol monomethyl ether, ethylene glycol monoethyl ether, ethylene glycol dimethyl ether, propylene glycol monomethyl ether, propylene glycol monoethyl ether, acetyl acetone, cyclohexanone, diacetone alcohol, ethylene glycol monomethyl ether acetate, ethylene glycol monoethyl ether acetate, ethylene glycol monoisoprpyl ether, ethylene glycol monobutyl ether acetate, 3-methoxypropanol, methoxymethoxy ethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, and ethyl lactate. These solvents may be used singly or in admixture. The concentration of the solid content in the coating solution is preferably from 1 to 50% by weight.

The composition for the photosensitive layer of photopolymerizable lithographic printing plate of the invention may comprise a surface active agent to improve the properties of coated surface of the photosensitive layer.

The dried coated amount of the photosensitive layer in the photopolymerizable lithographic printing plate of the invention is preferably from about 0.1 $g/m^2$ to about 10 $g/m^2$, more preferably from 0.3 $g/m^2$ to 5 $g/m^2$, and still more preferably from 0.5 $g/m^2$ to 3 $g/m^2$.

An oxygen barrier protective layer is provided on the photosensitive layer of the photopolymerizable lithographic printing plate of the invention to prevent the polymerization inhibition by oxygen.

In the photopolymerizable lithographic printing plate of the invention, one indexe of low oxygen barrier properties of the protective layer provided on the photosensitive layer is oxygen permeability. The protective layer of the invention exhibits oxygen permeability of not less than 1 x $10^{-15}$ [$cm^3$(STP)·cm/$cm^2$·sec·cmHg]. The oxygen permeability is a known physical property described in J. BRNDRUP, "POLYMER HANDBOOK" and defined by the following equation:

$$P = (Q \times L)/(\Delta P \times A \times t)$$

where

Q: permeation amount of oxygen [$cm^3$ (STP)]
L: thickness of film (cm)
A: area of film ($cm^2$)
t: time (sec)
ΔP: pressure difference (partial pressure on the supply side - partial pressure on the permeation side) (cmHg)

The oxygen permeability of protective layer of the invention is not less than 1 x $10^{-15}$ [$cm^3$(STP)·cm/$cm^2$·sec·cmHg], preferably not less than 1 x $10^{-13}$ [$cm^3$(STP)·cm/$cm^2$·sec·cmHg], more preferably not less than 1x$10^{-11}$ [$cm^3$(STP)·cm/$cm^2$·sec·cmHg], and still more preferably not less than 1 x $10^{-9}$ [$cm^3$(STP)·cm/$cm^2$·sec·cmHg]. The upper limit of the oxygen permeability of the protective layer of the invention is not particularly limited but is preferably not more than 1 x $10^{-1}$ [$cm^3$(STP)·cm/$cm^2$·sec·cmHg], more preferably not more than 1 x $10^{-3}$ [$cm^3$(STP)·cm/$cm^2$·sec·cmHg], and still more preferably not more than 1 x $10^{-5}$ [$cm^3$(STP)·cm/$cm^2$·sec·cmHg].

Another index of low oxygen barrier properties of the protective layer of the invention is that the oxygen

permeability of the protective layer is higher than that of a poly-vinyl alcohol layer having the same thickness as the protective layer. In other words, a polyvinyl alcohol is an organic polymer compound having the high oxygen barrier property, and the protective layer is a layer formed by an organic polymer having higher oxygen permeability than polyvinyl alcohol. The protective layer of the invention is not particularly limited in its material so far as it has the oxygen permeability as defined above. Examples of the material for the protective layer include water-soluble polymer compounds, for example, fully or partially saponified polyvinyl alcohol partially modified with ester, ether or acetal, cellulose, polyvinyl pyrrolidone, gelatin, polyacrylic acid, polymethacrylic acid, partially saponified polyvinyl acetate, polyacrylamide,vinyl pyrrolidone/vinyl acetate copolymer, saponification product of vinyl pyrrolidone/vinyl acetate copolymer, partial saponification product of vinyl pyrrolidone/vinyl acetate copolymer, vinyl acetate/vinyl phthalate copolymer, saponification product of vinyl acetate/vinyl phthalate copolymer, partial saponification product of vinyl acetate/vinyl phthalate copolymer, vinyl acetate/crotonic acid copolymer, saponification product of vinyl acetate/crotonic acid copolymer, partial saponification product of vinyl acetate/crotonic acid copolymer or gum arabic, and water-insoluble polymers, for example, polyethylene, polypropylene, polyethylene terephthalate, polystyrene, polycarbonate, nylon, polyamide or silicone.

A polymer compound having high the oxygen barrier property such as polyvinyl alcohol may be blended with an organic or inorganic compound capable of enhancing the oxygen permeability thereof or may be irradiated with radiation to form minute pores for enhancing the oxygen permeability thereof.

Specific examples of the organic compound for enhancing the oxygen permeability include water-soluble polymers, for example, polyvinyl pyrrolidone, gelatin, polyacrylic acid, partially saponified polyvinyl acetate or polyacrylamide, and low molecular compounds, for example, glycerin, pentaerthritol, alginic acid or sorbitol. Specific examples of the inorganic compound for enhancing the oxygen permeability include barium sulfate, barium carbonate, silica, calcium carbonate, talc, and alumina. The present invention is not necessarily limited to these compounds.

The material for the aforementioned protective layer is preferably a water-soluble polymer compound because it can be removed during development after the image formation and from the standpoint of adhesion. Particularly preferred materials are polyvinyl pyrrolidone, partially saponified polyvinyl acetate and a mixture of polyvinyl alcohol with a material capable of enhancing the oxygen permeability of polyvinyl alcohol.

The photopolymerizable lithographic printing plate of the invention can be prepared by applying a photosensitive solution having the photosensitive layer components dissolved in a solvent to a support, drying the coated material, and then laminated a film forming a protective layer on the photosensitive layer. Alternatively, the protective layer may be formed by coating and drying a solution for protective layer similar to the photosensitive solution.

The thickness of protective layer may be appropriately determined so as to meet the aforementioned requirements for oxygen permeability. Developing removability, scratch resistance, ink receptivity, etc. are also taken into account. In general, the more the thickness of protective layer is, the lower is the oxygen permeability and the more advantageous is the sensitivity. The more the thickness of protective layer is, the better is scratch resistance. On the contrary, the smaller the thickness of the protective layer is, the higher is the oxygen permeability and the more advantageous is the flare resistance. The smaller the thickness of protective layer is, the better are the developability and ink receptivity, The thickness of the protective layer is preferably from 0.5 to 50 μm. When a developable water-soluble polymer is used, the thickness is preferably from 0.5 to 5 μm and more preferably from 1 to 3 μm, and when a water-insoluble polymer, e.g., polyolefin is used, it is preferably from 10 to 50 μm and more preferably from 15 to 45 μm. In the case where the protective layer is formed by coating and drying, an aqueous solution of a water-soluble polymer compound or a solution having a water-insoluble polymer compound dissolved in a solvent is applied and dried similar to the solution for photosensitive layer.

The support for the photopolymerizable lithographic printing plate of the invention will be described hereinafter.

An aluminum support for use in the invention includes aluminum or aluminum alloy (e.g., alloy of aluminum with silicon, copper, manganese, magnesium, chromium, zinc, lead, bismuth or nickel) plate, which is dimensionally stable, or plastic film or paper laminated with aluminum or aluminum alloy or having aluminum or aluminum alloy vacuum-deposited thereon. The thickness of aluminum support is ordinarily from about 0.05 to 1 mm. Alternatively, a composite sheet as described in Japanese Patent Laid-Open No. 1973-18327 may be used.

The aluminum support for use in the invention is appropriately subjected to surface treatment in the following manner.

(Graining treatment)

Examples of the graining method include mechanical graining, chemical etching, and electrolytic graining as disclosed in Japanese Patent Laid-Open No. 1981-28893. Further examples of graining method include electrochemical graining involving electrochemical graining in a hydrochloric acid or nitric acid electrolytic solution and mechanical graining method such as wire brush graining method involving scratching on the surface of aluminum sheet with metal wire, ball graining method involving graining on the surface of aluminum sheet with abrasive ball and abrasive and

brush graining method involving graining on the surface of aluminum sheet with nylon brush and abrasive. These graining methods may be used singly or in combination.

Among these methods for forming surface roughness, the electrochemical method involving chemical graining in a hydrochloric acid or nitric acid electrolytic solution is useful. The current density is preferably from 100 to 400 C/ $dm^2$. In more detail, electrolysis is preferably conducted under the conditions of an electrolytic solution containing from 0.1 to 50% of hydrochloric acid or nitric acid, a temperature of from 20 to 100°C, a period of from 1 second to 30 minutes and a current density of from 100 to 400 C/$dm^2$.

The aluminum support thus grained is then subjected to chemical etching with an acid or alkali. When an acid is used as an etchant, it takes much time to destroy the microstructure to the disadvantage of industrial application of the invention. However, the disadvantage can be eliminated by the use of an alkali as the etchant.

Examples of the alkali which can be preferably used include caustic soda, sodium carbonate, sodium aluminate, sodium metasilicate, sodium phosphate, potassium hydroxide, and lithium hydroxide. The concentration and temperature of alkali solution are preferably from 1% to 50% and from 20°C to 100°C, respectively. The electrolysis conditions are preferably determined such that the dissolved amount of Al is from 5 to 20 g/$m^2$.

The aluminum sheet thus etched is then subjected to washing with an acid to remove smut remaining on the surface thereof. As such an acid there may be used nitric acid, sulfuric acid, phosphoric acid, chromic acid, hydrofluoric acid, fluoroboric acid or the like. In particular, as a desmutting method to be effected after the electrochemical roughening there is preferably used a method involving contact with a sulfuric acid having a temperature of from 50 to 90°C and a concentration of from 15 to 65% by weight as described in Japanese Patent Laid-Open No. 1978-12739 or a method involving alkali etching as described in Japanese Patent Publication No. 1973-28123.

The surface roughness (Ra) of the Al support suitably used in the invention is ordinarily from 0.3 μm to 0.7 μm.

(Anodization treatment)

The aluminum support thus processed is then subjected to an anodization treatment.

The anodization treatment can be carried out by any method which has heretofore been known in the art. Specifically, when direct current or alternating current is applied to the aluminum support in an aqueous solution or non-aqueous solution comprising sulfuric acid, phosphoric acid, chromic acid, oxalic acid, sulfamic acid, benzenesulfonic acid, etc., singly or in combination of two or more thereof, an anodized film is formed on the surface of aluminum support.

The anodization conditions vary with the electrolytic solution used and thus cannot be unequivocally determined. In practice, however, the concentration of electrolytic solution, the temperature of electrolytic solution, the current density, the voltage and the electrolysis time are preferably from 1 to 80%, from 5 to 70°C, from 0.5 to 60 A/$dm^2$, from 1 to 100V, and from 10 to 100 seconds, respectively.

Particularly preferred anodization methods are method involving anodization in sulfuric acid at a high current density as described in British Patent No. 1,412,768 and method involving anodization in phosphoric acid as an electrolytic bath as described in US Patent 3,511,661.

In the invention, the amount of anodized film is preferably from 1 to 10 g/$m^2$. When the amount of anodized film is not greater than 1 g/$m^2$, the resulting printing plate can be easily damaged. On the contrary, it requires much electric power to produce an anodized film at an amount of not smaller than 10 g/$m^2$ to the disadvantage of economy. The amount of anodized film is preferably from 1.5 to 7 g/$m^2$, more preferably from 2 to 5 g/$m^2$.

In the invention, the aluminum support, which has been grained and anodized, may be subjected to a sealing treatment. The sealing treatment can be carried out by dipping the aluminum support in hot water or a hot aqueous solution of inorganic salt or organic salt, or subjecting the aluminum support to steam bathing. The aluminum support may be subjected to a treatment other than a silicate treatment with an alkaline metal silicate, for example, a surface treatment such as dipping in an aqueous solution of potassium fluorozirconate, phosphate or the like.

A photosensitive layer comprising the aforementioned photopolymerizable composition is formed on the aluminum support which has thus been subjected to the surface treatment to prepare a photosensitive lithographic printing plate of the invention. If desired, an organic or inorganic undercoating layer may be provided before the application of the photosensitive layer.

The aforementioned photosensitive layer of the photopolymerizable lithographic printing plate of the invention is imagewise exposed to known active rays such as carbon arc lamp, high pressure mercury vapor lamp, xenon lamp, metal halide lamp, fluorescent lamp, tungsten lamp, halogen lamp, helium cadmium laser, argon ion laser, FD·YAG laser, helium neon laser and semiconductor laser (350 nm to 600 nm), and then subjected to development to form an image on the aluminum support.

The developer for photopolymerizable lithographic printing plate of the invention is not particularly restricted but preferably comprises an inorganic alkali agent. The inorganic alkali agent is not particularly limited. Examples of the inorganic alkali agent include sodium tertiary phosphate, potassium tertiary phosphate, ammonium tertiary phosphate, sodium carbonate, potassium carbonate, ammonium carbonate, sodium hydrogencarbonate, potassium hydrogencarbonate, ammonium hydrogencarbonate, sodium borate, potassium borate, ammonium borate, sodium hydroxide, potassium hydroxide, ammonium hydroxide, lithium hydroxide, sodium silicate, potassium silicate, ammonium silicate, sodium metasilicate, potassium metasilicate, and ammonium metasilicate.

An organic alkali agent may be complementarily used for the purpose of closely adjusting the alkali concentration or of aiding dissolution of the photosensitive layer. Examples of the organic alkali agent include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide.

The alkali agents may be used singly or in combination of two or more thereof.

The pH value of the developer used in the development of photopolymerizable lithographic printing plate of the invention is preferably from 10.0 to 12.8. When the pH value of developer falls below the range, the desired image may not be formed. On the contrary, when the pH value of developer exceeds the range, overdevelopment occurs, resulting in causing a problem of damage on development at the exposed area. The pH value of developer is more preferably from 11.0 to 12.5.

The developer used in the development of photopolymerizable lithographic printing plate of the invention may further comprise a surface active agent as described below. Examples of the surface active agent include nonionic surface active agents, for example, polyoxyethylene alkyl ether (e.g., polyoxyethylene lauryl ether, polyoxyethyene cetyl ether, polyoxyethylene stearyl ether), polyoxyethylene alkyl aryl ether (e.g., polyoxyethylene octyl phenyl ether, polyoxyethylene nonyl phenyl ether), polyoxyethylene alkyl ester (e.g., polyoxyethylene stearate), sorbitan alkylester (e.g., sorbitan monolaurate, sorbitan monostearate, sorbitan distearate, sorbitan monooleate, sorbitan sesquioleate, sorbitan trioleate) and monoglyceride alkyl ester (e.g., glycerol monostearate, glycerol monooleate), anionic surface active agents, for example, alkylbenzenesulfonate (e.g. sodium dodecylbenzenesulfonate), alkylnaphthalenesulfonate (e.g., sodium butylnaphthalenesulfonate, sodium pentylnaphthalenesulfonate, sodium hexylnaphthalenesulfonate, sodium octylnaphthalenesulfonate), alkylsulfate (e.g., sodium laurylsulfate), alkylsulfonate (e.g., sodium dodecylsulfonate) and sulfosuccinic acid ester salt (e.g., sodium dilaurylsulfosuccinate), and amphoteric surface active agents, for example, alkyl betaine (e.g., lauryl betaine, stearyl betaine) and amino acid. Of the surface active agents, a nonionic surface active agent containing a polyoxyalkylene ether group and having a structure of formula (II) described below is preferably used.

$$R^{14} - O - (R^{15} - O)_nH \qquad (II)$$

wherein $R^{14}$ represents a $C_3$-$C_{15}$ alkyl group which may have a substituent, a $C_6$-$C_{15}$ aromatic hydrocarbon group which may have a substituent or a $C_4$-$C_{15}$ heterocyclic aromatic group which may have a substituent (examples of the substituent including a $C_1$-$C_{20}$ alkyl group, a halogen atom, e.g., Br, Cl or I, a $C_6$-$C_{15}$ aromatic hydrocarbon group, a $C_7$-$C_{17}$ aralkyl group, a $C_1$-$C_{20}$alkoxy group, a $C_2$-$C_{20}$ alkoxycarbonyl group and a $C_2$-$C_{15}$ acyl group); $R^{15}$ represents a $C_1$-$C_{100}$ alkylene group which may have a substituent (examples of the substituent including a $C_1$-$C_{20}$ alkyl group and a $C_6$-$C_{15}$ aromatic hydrocarbon group); and n represents an integer of from 1 to 100.

In formula (II), ($R^{15}$ - O)'s may be different so far as they meet the aforementioned requirements. Specific examples of the combination of moieties ($R^{15}$ - O) include random or block chain of combination of ethylene oxy group and propylene oxy group, ethylene oxy group and isopropylene oxy group, ethylene oxy group and butylene oxy group, and ethylene oxy group and isobutylene oxy group.

The surface active agents may be used singly or in combination. The content of surface active agent in the developer is preferably from 0.1 to 20% by weight as calculated in terms of effective content.

The developer used in the development of photopolymerizable lithographic printing plate of the invention may comprise the following components besides the aforementioned components, if desired. Examples of the component include organic carboxylic acids, e.g., benzoic acid, phthalic acid, p-ethylbenzoic acid, p-n-propylbenzoic acid, p-isopropylbenzoic acid, p-n-butylbenzoic acid, p-tert-butylbenzoic acid, p-2-hydroxyethylbenzoic acid, decanoic acid, salicylic acid or 3-hydroxy-2-naphthoic acid, organic solvents, e.g., isopropyl alcohol, benzyl alcohol, ethyl cellosolve, butyl cellosolve, phenyl cellosolve, propylene glycol or diacetone alcohol, chelating agents, reducing agents, dyes, pigments, water softeners, preservatives, and defoaming agents.

The lithographic printing plate, which has been imagewise exposed to light, may be subjected to heating at a temperature of from 50 to 150°C for 1 second to 5 minutes for the purpose of enhancing the hardening rate of the photopolymerizable photosensitive layer between the imagewise exposure and development.

As described above, the photopolymerizable lithographic printing plate of the invention comprises the protective layer having oxygen barrier property provided on the photosensitive layer. To eliminate the protective layer, a

method which comprises removing the protective layer and the unexposed area of the photosensitive layer at the same time with a developer and a method which comprises removing the protective layer with water or hot water, and then removing the unexposed area of the photosensitive layer with a developer. The water or hot water may comprise a preservative or the like as disclosed in Japanese Patent Laid-Open No. 1998-10754 or an organic solvent or the like as disclosed in Japanese Patent Laid-Open No. 1997-278636.

The development of the photopolymerizable lithographic printing plate of the invention with the aforementioned developer is carried out at a temperature of from 0 to 60°C, preferably from 15 to 40°C in a conventional manner, for example, by rubbing the exposed photopolymerizable lithographic printing plate with a brush in the developer.

When the development process is conducted using an automatic developing machine, the developer undergoes fatigue according to the processing amount of the photopolymerizable lithographic printing plate. Thus, a replenisher or a fresh developer may be used to restore the processing capacity.

The photopolymerizable lithographic printing plate thus developed is then subjected to post-treatment with washing water, a rinse solution containing a surface active agent or the like, or a desensitizing solution containing gum arabic, starch derivative or the like as described in Japanese Patent Laid-Open No. 1979-8002, Japanese Patent Laid-Open No. 1980-115045 and Japanese Patent Laid-Open No. 1984-58431. The photopolymerizable lithographic printing plate of the invention may be subjected to the post-treatments in various combinations.

The printing plate thus obtained may be then subjected to post-exposure treatment as disclosed in Japanese Patent Laid-Open No. 2000-89478 or heat treatment such as burning to inprove its press life.

The lithographic printing plate thus obtained is then mounted on an offset printing machine to perform printing of a large number of sheets.

The invention will be described in more detail with reference to the following examples, but the invention should not be construed as being limited thereto.

EXAMPLES 1 - 20 AND COMPARATIVE EXAMPLES 1 - 4

A negative-working photosensitive lithographic printing plate was prepared in the following manner. The negative-working photosensitive lithographic printing plate thus prepared was then evaluated for printing properties. The results are set forth in Table 2.

[Preparation of support]

A JIS A 1050 aluminum plate having a thickness of 0.24 mm and a width of 1,030 mm was subjected to continuous processing in the following manner.

(a) Using an existing mechanical graining device, the aluminum plate was mechanically grained by rotary roller-form nylon brushes while an aqueous suspension of an abrasive (pumice stone) having a specific gravity of 1.12 as a slurry solution of abrasive was being supplied onto the surface thereof. The abrasive had an average particle diameter of from 40 μm to 45 μm and a maximum particle diameter of 200 μm. The nylon brush was made of 6.10 nylon and had a bristle length of 50 mm and a bristle diameter of 0.3 mm. The nylon brush had bristles densely planted on a stainless steel cylinder having a diameter ϕ of 300 mm. Three such rotary brushes were used. The distance between two supporting rollers (ϕ200 mm) disposed under the brush was 300 mm. The brush roller was pressed against the aluminum plate until the load on the drive motor for rotating the brush reached 7 kw greater than that on the drive motor developed when the brush roller was not pressed against the aluminum plate. The direction of rotation of the brush was the same as the moving direction of the aluminum plate. The rotary speed of the brush was 200 rpm.

(b) The aluminum plate thus grained was spray-etched with a solution having a caustic soda concentration of 2.6% by weight and an aluminum ion concentration of 6.5% by weight at a temperature of 70°C until it was dissolved in an amount of 13 $g/m^2$. Thereafter, the aluminum plate was spray-rinsed.

(c) The aluminum plate was spray-desmutted with a 1 wt-% aqueous solution of nitric acid of 30°C (containing 0.5% by weight of aluminum ion), and then spray-rinsed. The aqueous solution of nitric acid used for desmutting was a waste liquid from a step of electrochemical graining in an aqueous solution of nitric acid using alternating current.

(d) The aluminum plate was subjected to continuous electrochemical graining using 60 Hz a.c. voltage. The electrolyte used in the electrochemical graining step was a 1 wt-% aqueous solution of nitric acid (containing 0.5% by weight of aluminum ion and 0.007% by weight of ammonium ion). The temperature of the electrolyte was 40°C. As the a.c. there was used a trapezoidal rectangular a.c. having TP (time required until the current value reached peak from zero) of 2 msec and a duty ratio of 1 : 1. A carbon electrode was used as a counter electrode. As an auxiliary anode there was used ferrite. The current density was 30 $A/cm^2$ when the current was at peak. The

quantity of electricity used was 255 $C/cm^2$ as calculated in terms of sum of quantity of electricity consumed when the aluminum plate was the anode. 5% of current from the power supply was branched to the auxiliary anode. Thereafter, the aluminum plate was spray-rinsed.

(e) The aluminum plate was spray-etched with a solution having a caustic soda concentration of 26% by weight and an aluminum ion concentration of 6.5% by weight at a temperature of 32°C until it was dissolved in an amount of 0.2 $g/m^2$. In this manner, smut mainly composed of aluminum hydroxide produced by the electrochemical graining at the previous stage was removed and the edge on the pit thus produced was dissolved and smoothened. The aluminum plate was then spray-rinsed.

(f) The aluminum plate was spray-desmutted with a 25 wt-% aqueous solution of sulfuric acid (containing aluminum ion in an amount of 0.5% by weight) at a temperature of 60°C, and then spray-rinsed.

(g) Using an existing two-stage power supply electrolysis process anodizing device (length of first and second electrolysis zones: 6 m each; length of first power supply zone: 3 m; length of second power supply zone: 3 m; length of first and second power supply electrodes: 2.4 m each), the aluminum plate was then anodized at a temperature of 38°C under the conditions that the concentration of sulfuric acid in the electrolysis zone was 170 g/l (containing aluminum ion in an amount of 0.5% by weight). The aluminum plate was then spray-rinsed. During the procedure, in the anodization device, the current from the power supply was supplied into the first power supply electrode provided in the first power supply zone from which it was then passed to the plate-like aluminum in the first electrolysis zone through the electrolyte to form an oxide film on the surface of the plate-like aluminum. The current was passed to the electrolysis electrode provided in the first power supply zone from which it was then returned to the power supply. On the other hand, the current from the power supply was also supplied into the second power supply electrode provided in the second power supply zone from which it was then passed to the plate-like aluminum in the second electrolysis zone through the electrolyte to form an oxide film on the surface of the plate-like aluminum. The quantity of electricity supplied from the power supply into the first power supply zone was the same as the quantity of electricity supplied from the power supply into the second power supply zone. The density of current supplied onto the oxide film in the second power supply zone was about 25 $A/cm^2$. In the second power supply zone, power was supplied through an oxide film having a density of 1.35 $g/m^2$. The final amount of oxide film was 2.7 $g/m^2$. The aluminum support thus prepared will be hereinafter referred to as "[AS-1]".

[Hydrophilic treatment]

The aluminum support [AS-1] was then treated with silicate to enhance hydrophilicity suitable for non-image area of printing plate. For the treatment, the aluminum support was conveyed through a 1.5% aqueous solution of No. 3 sodium, silicate kept at 70°C in such a manner that the aluminum web was brought into contact with the aqueous solution for 15 seconds. The aluminum support was then washed with water. The attached amount of Si was 10 $mg/m^2$. The support thus prepared will be hereinafter referred to as "[AS-2]".

[Provision of interlayer]

An SG process liquid composition (sol) was prepared in the following manner. The following components were measured out in a beaker where they were then stirred at a temperature of 25°C for 20 minutes.

| | |
|---|---|
| Tetraethoxysilane | 38 g |
| 3-Methacryloylpropyl timethoxysilane | 13 g |
| 85% Aqueous solution of phosphoric acid | 12 g |
| Ion-exchanged water | 15 g |
| Methanol | 100 g |

The solution thus prepared was then transferred into a three-necked flask to which a reflux condenser was then attached. The three-necked flask was dipped in an oil bath at room temperature. The contents of the three-necked flask were then heated to a temperature of 50°C in 30 minutes while being stirred by a magnetic stirrer. The reaction mixture was further reacted at a bath temperature kept to 50°C for 1 hour to obtain a liquid composition (sol). The sol thus obtained was diluted with a 20/1 (by weight) mixture of methanol and ethylene glycol to a concentration of 0.5% by weight, applied to the aluminum substrate [AS-1] by means of a wheeler, and then dried at a temperature of 100°C for 1 minute. The coated amount of the solution was 3.5 $mg/m^2$. For the determination of the coated amount, the amount of Si element was determined by fluorescent X-ray analysis. The support thus prepared will be hereinafter referred to as "[AS-3]".

Subsequently, the aluminum support [AS-2] was coated with a solution having the following composition by

means of a wire bar, and then dried at a temperature of 90°C in a hot air dryer for 30 seconds. The dried coated amount of the solution was 10 mg/$m^2$.

| | |
|---|---|
| Copolymer of ethyl methacrylate and sodium 2-acrylamido-2-methyl-1-propanesulfonate (75/25 by molar ratio) | 0.1 g |
| 2-Amonoethylphosphonic acid | 0.1 g |
| Methanol | 50 g |
| Ion-exchanged water | 50 g |

The support thus prepared will be hereinafter referred to as "[AS-4]".
The aluminum support [AS-2] was coated with a solution having the following composition by means of a wire bar, and then dried at a temperature of 100°C in a hot air dryer for 30 seconds. The dried coated amount of the solution was 30 mg/$m^2$.

| | |
|---|---|
| Quaternary ammonium salt polymer represented by formula shown below (weight average molecular weight determined by GPC method: 50,000) | 0.75 g |
| Methanol | 200 g |

The support thus prepared will be hereinafter referred to as "[AS-5]".

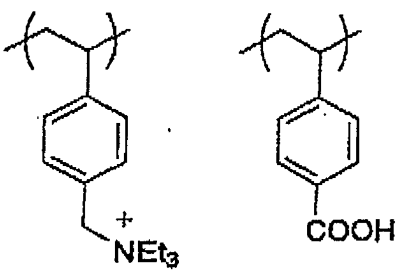

(copolymerization ratio: 15/85)

The aluminum support [AS-1] was coated with a solution having the following composition by means of a wire bar, and then dried in a hot air dryer at a temperature of 100°C for 30 seconds. The dried coated amount of the solution was 10 mg/$m^2$.

| | |
|---|---|
| Phenylphosphonic acid | 0.25 g |
| Methanol | 200 g |

The support thus prepared will be hereinafter referred to as "[AS-6]".

[Provision of photosensitive layer]

A negative-working photosensitive composition having the following formulation was applied to the aluminum support described above in an amount such that the dried coated amount was as set forth in Table 7, and then dried at a temperature of 100°C for 1 minute to form a photosensitive layer thereon.

| (Negative-working photosensitive composition) | |
|---|---|
| Addition-polymerizable compound (as set forth in Table 7) | X g |
| Binder polymer (compound as set forth in Table 7) | 2.0 g |
| Sensitizing dye (compound as set forth in Table 7) | 0.2 g |
| Photopolymerization initiator (compound as set forth in Table 7) | 0.4 g |
| Co-sensitizing dye (compound as set forth in Table 7) | 0.4 g |
| Fluorine-based nonionic surface active agent (Megafac F-177, produced by Dainippon Ink & Chemicals, Inc.) | 0.03 g |

(continued)

| (Negative-working photosensitive composition) | |
|---|---|
| Heat polymerization inhibitor (N-nitrosophenylhydroxylamine aluminum salt) | 0.01 g |
| Coloring pigment dispersion having the following composition | 2.0 g |
| Methyl ethyl ketone | 20.0 g |
| Propylene glycol monomethyl ether | 20.0 g |

(Composition of coloring pigment dispersion)

| | |
|---|---|
| Pigment Blue 15 : 6 | 15 parts by weight |
| Allyl methacrylate-methacrylic acid copolymer | 10 parts by weight |
| (Copolymerization molar ratio: 80/20; weight average molecular weight: 40,000) Cyclohexanone | 15 parts by weight |
| Methoxypropyl acetate | 20 parts by weight |
| Propylene glycol monomethyl ether | 40 parts by weight |

[Provision of protective layer]

A protective layer having the composition shown below was provided on the photosensitive layer as set forth in Table 7.

Protective layer (O-1) :

A protective layer having a thickness of 2 µm formed by applying a 10 wt-% aqueous solution of polyvinyl alcohol (saponification degree: 70) to the photosensitive layer by means of a wire bar, and then drying the coated material at a temperature of 100°C for 2 minutes

Protective layer (O-2):

A protective layer having a thickness of 3 µm formed by applying a 10 wt-% aqueous solution of polyvinylpyrrolidone to the photosensitive layer by means of a wire bar, and then drying the coated material at a temperature of 100°C for 2 minutes

Protective layer (O-3):

A protective layer having a thickness of 3 µm formed by applying a 10 wt-% aqueous solution of a 7/3 (by weight) mixture of polyvinyl alcohol (saponification degree: 99.9) and sodium p-toluenesulfonate to the photosensitive layer by means of a wire bar, and then drying the coated material at a temperature of 100°C for 2 minutes

Protective layer (O-4):

A protective layer having a thickness of 1.8 µm formed by applying a 10 wt-% aqueous solution of a vinylpyrrolidone/vinyl acetate/vinyl alcohol copolymer (copolymerization molar ratio: 5/1/4) to the photosensitive layer by means of a wire bar, and then drying the coated material at a temperature of 100°C for 2 minutes

Protective layer (O-5):

A protective layer having a thickness of 2.5 µm formed by applying a 10 wt-% aqueous solution of a 5 : 5 (by weight) blend of a vinylpyrrolidone/vinyl acetate copolymer (copolymerization molar ratio: 7/3) and polyvinyl alcohol (saponification degree: 99.9) to the photosensitive layer by means of a wire bar, and then drying the coated material at a temperature of 100°C for 2 minutes

Comparative protective layer (OR-1):

A protective layer having a thickness of 2.5 μm formed by applying a 10 wt-% aqueous solution of polyvinyl alcohol (saponification degree: 99.9) to the photosensitive layer by means of a wire bar, and then drying the coated material at a temperature of 100°C for 2 minutes

The oxygen permeability of each of Protective layers (O-1) to (O-5) was more than 1 x $10^{-15}$ [$cm^3$(STP)·cm/$cm^2$·sec·cmHg] and that of Comparative protective layer (OR-1) was 6.7 x $10^{-16}$ [$cm^3$(STP)·cm/$cm^2$·sec·cmHg].

[Evaluation of negative-working photosensitive lithographic printing plate]

The negative-working photosensitive lithographic printing plate thus obtained was then exposed to light from a xenon lamp through an optical filter with Fuji Step Guide (gray scale having a discontinuous change of transmission optical density at ΔD = 0.15) produced by Fuji Photo Film Co., Ltd. in close contact therewith in such a manner that a known exposure energy was given. As the optical filter there was used Kenko BP-53 enabling exposure to monochromic light at 532 nm for the purpose of estimating the exposure aptitude to short wave semiconductor laser beam. Thereafter, the negative-working photosensitive lithographic printing plate thus exposed was dipped in a developer set forth in Table 7 below at a temperature of 25°C for 10 seconds so that it was subjected to development. An ink was then attached to the image area on the lithographic printing plate. The sensitivity (clear sensitivity) was then calculated from the maximum number of steps in which the image was obtained. The term "clear sensitivity" as used herein is meant to indicate the minimum energy required to form an image. The lower the clear sensitivity is, the higher is the sensitivity of the negative-working photopolymerizable lithographic printing plate. The results are set forth in Table 7 below.

(Evaluation of scumming)

Using an FD-YAG (532 nm) laser exposing machine (plate setter (Gutenberg) produced by HEIDELBERG JAPAN K.K.), the negative-working photosensitive lithographic printing plate thus obtained was exposed to a solid image and a halftone image having 2,540 dpi, 175 lines/inch and dots changing in density from 1% to 99% by 1% while the exposure power was being adjusted so that the density of exposure energy on the surface of the printing plate was 200 μJ/$cm^2$. Using an FLP-813 automatic developing machine produced by Fuji Photo Film Co., Ltd. loaded with the developer set forth in Tables 7 and 8 and an FP-2W finisher produced by Fuji Photo Film Co., Ltd., the negative-working photosensitive lithographic printing plate thus exposed was subjected to development/plate making at a developer temperature of 30°C for 18 seconds to obtain a lithographic printing plate. The lithographic printing plate thus obtained was mounted on a Dia IF2 printing machine produced by Mitsubishi Heavy Industries, Ltd. Using a GEOS G red ink (S) produced by Dainippon Ink & Chemicals, Inc., printing was conducted. The printed matter at 1,000th sheet was then visually evaluated for ink stain on the non-image area.

The compounds set forth in Tables 7 and 8 are described below.

[Addition-polymerizable compound]

M-1: Pentaerythritol tetraacrylate (NK Ester A-TMMT, produced by Shinnakamura Chemical Co., Ltd.)
M-2: Glycerin dimethacrylate hexamethylene diisocyanate urethane prepolymer (UA101H, produced by Kyoeisha Chemical Co., Ltd.)
M-3: Compound having the following formula:

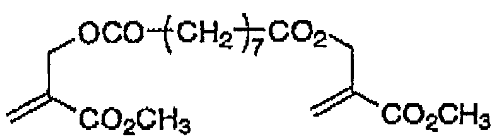

[Photopolymerization initiator]

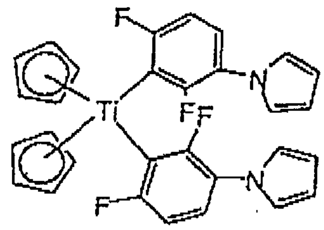

I-1

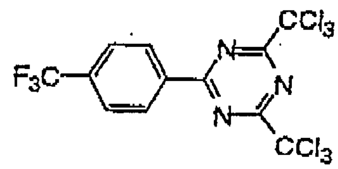

I-2

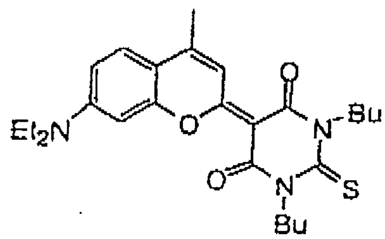

S-1

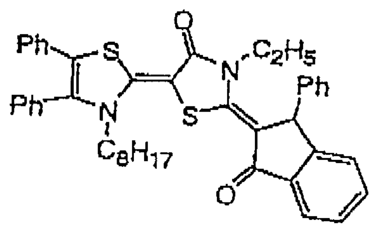

S-2

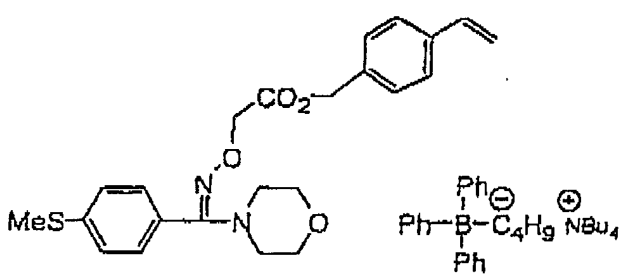

C-1

C-2

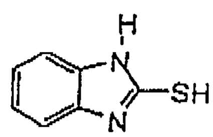

C-3

[Binder polymer]

P-1: Allyl methacrylate/methacrylic acid copolymer (copolymerizationmolar ratio: 80/20; acidvalue measured by NaOH titration: 1.70 meq/g; weight average molecular weight measured by GPC: 48,000)
P-2: Modified polyvinyl alcohol having the following composition:

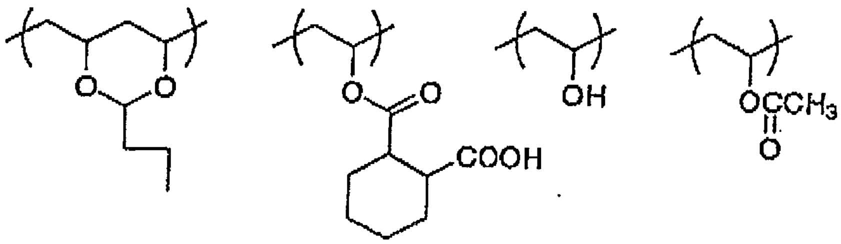

Composition ratio (molar ratio): 55/28/15/2
Molecular weight: 105,000
P-3: Polyurethane resin of polycondensate of the following diisocyanates with the following diols: 4,4'-Diphenylmethane diisocyanate (MDI) Hexamethylene diisocyanate (HMDI) Polypropylene glycol (weight average molecular weight: 1,000) (PPG1000) 2,2-Bis(hydroxymethyl)propionic acid (DMPA) (Copolymerization molar ratio (MDI/HMDI/PPG1000/DMPA) : 40/10115/35; acid value measured by NaOH titration: 1.05 meq/g; weight average molecular weight measured by GPC: 45,000)

[Developer]

| | |
|---|---|
| D-1: Developer of pH 13.0 having the following composition: | |
| 1 K potassium silicate | 2.4 parts by weight |
| Potassium hydroxide | 1.5 parts by weight |
| Compound of Formula 1 shown below | 6.0 parts by weight |
| Compound of Formula 3 shown below | 0.2 parts by weight |
| Water | 89.9 parts by weight |
| D-2: Developer of pH 12.0 having the following composition: | |
| 1 K potassium silicate | 2.4 parts by weight |
| Potassium hydroxide | 0.2 parts by weight |
| Compound of Formula 2 shown below | 5.0 parts by weight |
| Compound of Formula 3 shown below | 0.1 parts by weight |
| Water | 92.3 parts by weight |
| D-3: Developer of pH 11.8 having the following composition: | |
| Triethanolamine | 1.5 parts by weight |
| Potassium hydroxide | 0.16 parts by weight |
| Compound of Formula 2 shown below | 5.0 parts by weight |
| Water | 93.34 parts by weight |

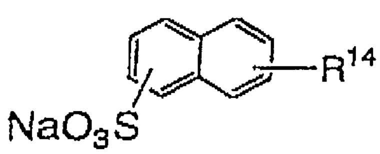

(Formula 1)

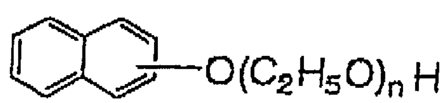

n: about 13

(Formula 2)

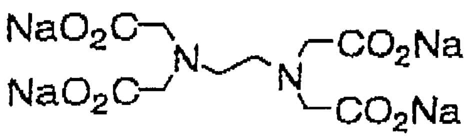

(Formula 3)

In Formula 1, $R^{14}$ represents either a hydrogen atom or butyl group. Namely, the compound of Formula 1 is a mixture of sodium naphthalenesulfonate and sodium butyl-substituted naphthalenesulfonate.

Table 7

| | Support | Photosensitive layer | | | | | | Protective layer | Developer | Sensitivity [μJ/cm$^2$] | Scumming |
|---|---|---|---|---|---|---|---|---|---|---|---|
| | | Addition-polymerizable compound (amount) | Binder polymer | Photopolymerization initiator | Sensitizing dye | Co-sensitizer | Dried coated amount (g/m$^2$) | | | | |
| Example 1 | AS-1 | M-1 1.8 | P-1 | I-1 | S-1 | C-1 | 1.2 | O-1 | D-2 | 180 | None |
| Example 2 | AS-1 | M-1 2.4 | P-2 | I-1 | S-2 | C-1 | 1.3 | O-2 | D-3 | 200 | None |
| Example 3 | AS-5 | M-2 2.0 | P-3 | I-2 | S-1 | C-3 | 1.4 | O-3 | D-2 | 180 | None |
| Example 4 | AS-2 | M-3 2.8 | P-1 | I-1 | S-2 | C-1 | 1.4 | O-4 | D-1 | 170 | None |
| Example 5 | AS-3 | M-2 2.7 | P-2 | I-1 | S-2 | C-2 | 1.3 | O-5 | D-3 | 210 | None |
| Example 6 | AS-4 | M-3 3.8 | P-2 | I-2 | S-1 | C-3 | 1.6 | O-1 | D-2 | 160 | None |
| Example 7 | AS-6 | M-1 3.0 | P-3 | I-1 | S-1 | C-2 | 1.2 | O-3 | D-2 | 180 | None |
| Example 8 | AS-3 | M-3 3.2 | P-1 | I-2 | S-2 | C-1 | 1.4 | O-4 | D-3 | 200 | None |
| Example 9 | AS-1 | M-2 1.8 | P-3 | I-2 | S-1 | C-1 | 1.5 | O-2 | D-2 | 220 | None |
| Example 10 | AS-5 | M-1 4.5 | P-3 | I-2 | S-2 | C-2 | 1.5 | O-2 | D-1 | 200 | None |
| Example 11 | AS-3 | M-2 3.6 | P-2 | I-1 | S-2 | C-1 | 1.4 | O-5 | D-2 | 180 | None |
| Example 12 | AS-2 | M-3 3.6 | P-1 | I-1 | S-2 | C-1 | 1.3 | O-4 | D-3 | 180 | None |
| Example 13 | AS-1 | M-3 2.5 | P-3 | I-2 | S-1 | C-1 | 1.4 | O-5 | D-2 | 190 | None |
| Example 14 | AS-5 | M-3 2.4 | P-2 | I-1 | S-2 | C-3 | 1.7 | O-2 | D-1 | 190 | None |
| Example 15 | AS-6 | M-1 2.2 | P-2 | I-2 | S-1 | C-1 | 1.4 | O-3 | D-3 | 220 | None |
| Example 16 | AS-4 | M-2 1.8 | P-1 | I-1 | S-2 | C-1 | 1.3 | O-2 | D-1 | 160 | None |
| Example 17 | AS-1 | M-3 2.0 | P-1 | I-2 | S-1 | C-1 | 1.5 | O-1 | D-2 | 170 | None |
| Example 18 | AS-3 | M-3 2.0 | P-2 | I-1 | S-2 | C-3 | 1.7 | O-5 | D-1 | 170 | None |
| Example 19 | AS-1 | M-3 2.3 | P-1 | I-1 | S-2 | C-3 | 1.5 | O-3 | D-1 | 160 | None |
| Example 20 | AS-6 | M-1 2.2 | P-3 | I-2 | S-1 | C-1 | 1.4 | O-2 | D-3 | 180 | None |
| Comparative Example 1 | AS-5 | M-1 0.8 | P-2 | I-1 | S-1 | C-1 | 1.4 | O-3 | D-1 | Image not formed | None |
| Comparative Example 2 | AS-3 | M-3 1.0 | P-1 | I-2 | S-2 | C-1 | 1.4 | O-5 | D-2 | Image not formed | None |
| Comparative Example 3 | AS-1 | M-2 2.0 | P-3 | I-1 | S-1 | C-2 | 1.4 | OR-1 | D-3 | 210 | Occurred |
| Comparative Example 4 | AS-6 | M-2 2.2 | P-1 | I-2 | S-2 | C-2 | 1.4 | OR-1 | D-2 | 220 | Occurred |

EXAMPLES 21 - 30 AND COMPARATIVE EXAMPLES 5 - 7

Negative-working photosensitive lithographic printing plates set forth in Table 8 were prepared. The negative-working photosensitive lithographic printing plates were then exposed to a semiconductor laser beam having a wavelength of 405 nm while the exposure power was being adjusted such that the density of exposure energy on the surface of the plate was 80 $\mu J/cm^2$. Thus, the negative-working photosensitive lithographic printing plates were evaluated for properties in the same manner as in Examples 1 to 20.

Table 8

| | Support | Photosensitive layer | | | | | | Protective layer | Developer | Sensitivity ($\mu J/cm^2$) | Scumming |
|---|---|---|---|---|---|---|---|---|---|---|---|
| | | Addition-polymerizable compound (amount) | Binder polymer | Photopolymerization initiator | Sensitizing dye | Co-sensitizer | Dried coated amount ($g/m^2$) | | | | |
| Example 21 | AS-1 | M-1 2.0 | P-1 | I-1 | S-3 | C-1 | 1.4 | O-3 | D-3 | 50 | None |
| Example 22 | AS-2 | M-3 2.5 | P-2 | I-1 | S-3 | C-1 | 1.3 | O-2 | D-2 | 60 | None |
| Example 23 | AS-6 | M-3 2.8 | P-3 | I-2 | S-4 | C-2 | 1.4 | O-5 | D-2 | 65 | None |
| Example 24 | AS-3 | M-2 3.0 | P-1 | I-1 | S-3 | C-3 | 1.7 | O-4 | D-1 | 50 | None |
| Example 25 | AS-6 | M-1 2.0 | P-2 | I-2 | S-4 | C-1 | 1.4 | O-1 | D-3 | 80 | None |
| Example 26 | AS-4 | M-2 1.7 | P-3 | I-1 | S-4 | C-1 | 1.3 | O-1 | D-1 | 70 | None |
| Example 27 | AS-1 | M-3 1.9 | P-3 | I-2 | S-3 | C-2 | 1.5 | O-2 | D-2 | 55 | None |
| Example 28 | AS-3 | M-3 2.0 | P-1 | I-1 | S-3 | C-3 | 1.7 | O-5 | D-3 | 55 | None |
| Example 29 | AS-1 | M-2 3.0 | P-2 | I-1 | S-4 | C-3 | 1.5 | O-4 | D-1 | 50 | None |
| Example 30 | AS-5 | M-1 2.6 | P-1 | I-2 | S-3 | C-1 | 1.4 | O-1 | D-2 | 60 | None |
| Comparative Example 5 | AS-3 | M-1 0.8 | P-1 | I-1 | S-4 | C-3 | 1.4 | O-3 | D-3 | Image not formed | None |
| Comparative Example 6 | AS-3 | M-3 1.8 | P-2 | I-2 | S-3 | C-1 | 1.4 | OR-1 | D-1 | 70 | Occurred |
| Comparative Example 7 | AS-1 | M-2 2.0 | P-3 | I-1 | S-4 | C-2 | 1.4 | OR-1 | D-2 | 60 | Occurred |

S-3

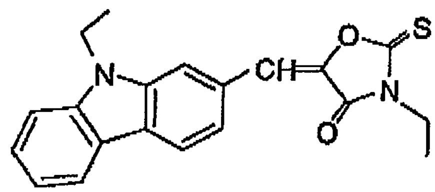

S-4

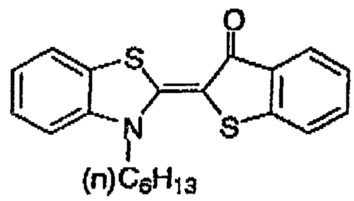

As can be seen in Tables 7 and 8 above, the photopolymerizable lithographic printing plates in the examples of the invention gave satisfactory results. On the contrary, the comparative photopolymerizable lithographic printing plates, in which the amount of the compound having an ethylenically unsaturated double bond in the photosensitive layer is less than 30% by weight based on the total weight of the photosensitive layer as in Comparative Examples 1, 2 and 5, and those, in which the oxygen permeability of the protective layer is less than 1 x $10^{-15}$ [$cm^3$(STP)·cm/$cm^2$·sec·cmHg] as in Comparative Examples 3, 4, 6 and 7 were unsatisfactory in some of the evaluation results.

As described above, the photopolymerizable lithographic printing plate of the invention comprises a compound having an ethylenically unsaturated double bond incorporated in the photosensitive layer in an amount of not smaller than 30% by weight and has a protective layer having an oxygen permeability of not less than 1 x 10-15 [$am^3$ (STP) ·cm/$cm^2$·sec·cmHg]. Thus, the photopolymerizable lithographic printing plate of the invention exhibits high sensitivity, high contrast and excellent flare resistance, i.e., less scumming.

The entire disclosure of each and every foreign patent application from which the benefit of foreign priority has been claimed in the present application is incorporated herein by reference, as if fully set forth herein.

While the invention has been described in detail and with reference to specific embodiments thereof, it will be apparent to one skilled in the art that various changes and modifications can be made therein without departing from the spirit and scope thereof.

## Claims

1. A photopolymerizable lithographic printing plate comprising a photosensitive layer containing a photopolymerization initiator, a compound having an ethylenically unsaturated double bond and a polymer binder, and a protective layer provided in this order on a hydrophilic support, wherein an amount of the compound having an ethylenically unsaturated double bond in the photosensitive layer is from 30% to 70% by weight based on the total weight of the photosensitive layer, and oxygen permeability of the protective layer is from 1 x $10^{-15}$ to 1 x $10^{-1}$ [$cm^3$(STP) ·cm/$cm^2$·sec·cmHg].

2. The photopolymerizable lithographic printing plate as claimed in Claim 1, wherein the amount of the compound having an ethylenically unsaturated double bond is from 40% to 60% by weight based on the total weight of the photosensitive layer.

3. The photopolymerizable lithographic printing plate as claimed in Claim 1, wherein the polymer binder is a polymer having an addition polymerizable group in its side chain.

4. The photopolymerizable lithographic printing plate as claimed in Claim 3, wherein the addition polymerizable group is an ethylenically unsaturated bond group.

5. The photopolymerizable lithographic printing plate as claimed in Claim 1, wherein the compound having an ethylenically unsaturated double bond is an α-hetero monomer represented by the following formula (I):

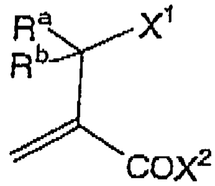

wherein $X^1$ and $X^2$, which may be the same or different, each represent a halogen atom or a group connected through a hetero atom; $R^a$ and $R^b$, which may be the same or different, each represent a hydrogen atom, a halogen atom, a cyano group or an organic residue; or $X^1$ and $X^2$, $R^a$ and $R^b$, or $X^1$ and $R^a$ or $R^b$ may combine with each other to form a cyclic structure.

**6.** The photopolymerizable lithographic printing plate as claimed in Claim 1, wherein the photopolymerization initiator is a titanocene compound.

**7.** A plate-making method of a photopolymerizable lithographic printing plate which comprises developing the photopolymerizable lithographic printing plate as claimed in Claim 1 with a developer having a pH of from 10.0 to 12.8 and containing a nonionic surface active agent represented by the following formula (II):

$$R^{14} - O - (R^{15} - O)_n H \qquad (II)$$

wherein $R^{14}$ represents a $C_3$-$C_{15}$ alkyl group which may have a substituent, a $C_6$-$C_{15}$ aromatic hydrocarbon group which may have a substituent or a $C_4$-$C_{15}$ heterocyclic aromatic group which may have a substituent; $R^{15}$ represents a $C_1$-$C_{100}$ alkylene group which may have a substituent; and n represents an integer of from 1 to 100.